# EUROPEAN PATENT SPECIFICATION

(11) **EP 4 129 682 B1**
(45) Date of publication and mention of the grant of the patent: **01.10.2025**
(21) Application number: 21189907.5
(22) Date of filing: 05.08.2021
(51) Int. Cl.: B41C 1/10, G03F 7/004, G03F 7/027, G03F 7/033, G03F 7/075, G03F 7/30

(54) **A LITHOGRAPHIC PRINTING PLATE PRECURSOR**
LITHOGRAFIEDRUCKPLATTENVORLÄUFER
PRÉCURSEUR DE PLAQUE D'IMPRESSION LITHOGRAPHIQUE

(43) Date of publication of application: 08.02.2023
(73) Proprietor: ECO3 BV, 2640 Mortsel (BE)
(72) Inventor: VAN AERT, Hubertus, 2640 Mortsel (BE); BILLIET, Thomas, 2640 Mortsel (BE)
(74) Representative: De Clercq & Partners

(56) References cited:
- EP-A1- 1 587 691
- EP-A1- 1 880 978
- EP-A2- 1 495 864
- EP-B1- 1 587 691
- JP-A- 2007 237 586
- US-A1- 2011 076 618

## Description

### Technical Field

The invention relates to a novel lithographic printing plate precursor.

### Background Art

Lithographic printing typically involves the use of a so-called printing master such as a printing plate which is mounted on a cylinder of a rotary printing press. The master carries a lithographic image on its surface and a print is obtained by applying ink to said image and then transferring the ink from the master onto a receiver material, which is typically paper. In conventional lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called driographic printing, the lithographic image consists of ink-accepting and ink-abhesive (ink-repelling) areas and during driographic printing, only ink is supplied to the master.

Lithographic printing masters are generally obtained by the image-wise exposure and processing of a radiation sensitive layer on a lithographic support. Imaging and processing renders the so-called lithographic printing plate precursor into a printing plate or master. Image-wise exposure of the radiation sensitive coating to heat or light, typically by means of a digitally modulated exposure device such as a laser, triggers a physical and/or chemical process, such as ablation, polymerization, insolubilization by cross-linking of a polymer or by particle coagulation of a thermoplastic polymer latex, solubilization by the destruction of intermolecular interactions or by increasing the penetrability of a development barrier layer. Although some plate precursors are capable of producing a lithographic image immediately after exposure, the most popular lithographic plate precursors require wet processing since the exposure produces a difference in solubility or difference in rate of dissolution in a developer between the exposed and the non-exposed areas of the coating. In positive working lithographic plate precursors, the exposed areas of the coating dissolve in the developer while the non-exposed areas remain resistant to the developer. In negative working lithographic plate precursors, the non-exposed areas of the coating dissolve in the developer while the exposed areas remain resistant to the developer. Most lithographic plate precursors contain a hydrophobic coating on a hydrophilic support, so that the areas which remain resistant to the developer define the ink-accepting, hence printing areas of the plate while the hydrophilic support is revealed by the dissolution of the coating in the developer at the non-printing areas.

Photopolymer printing plates rely on a working-mechanism whereby the coating - which typically includes free radically polymerisable compounds - hardens upon exposure. "Hardens" means that the coating becomes insoluble or non-dispersible in the developing solution and may be achieved through polymerization and/or crosslinking of the photosensitive coating upon exposure to light and/or heat. Photopolymer plate precursors can be sensitized to blue, green or red light i.e. wavelengths ranging between 450 and 750 nm, to violet light i.e. wavelengths ranging between 300 and 450 nm or to infrared light i.e. wavelengths ranging between 750 and 1500 nm. Optionally, the exposure step is followed by a heating step to enhance or to speed-up the polymerization and/or crosslinking reaction.

In general, a toplayer or protective overcoat layer over the imageable layer is required to act as an oxygen barrier to provide the desired sensitivity to the plate. A toplayer typically includes water-soluble or water-swellable polymers such as for example polyvinyl alcohol. Besides acting as barrier for oxygen, the toplayer should best be easily removable during processing and be sufficiently transparent for actinic radiation, e.g. from 300 to 450 nm or from 450 to 750 nm or from 750 to 1500 nm.

The classical workflow of photopolymer plates involves first an exposure step of the photopolymer printing plate precursor in a violet or infrared platesetter, followed by an optional pre-heat step, a wash step of the protective overcoat layer, an alkaline developing step, and a rinse and gum step. However, there is a clear evolution in the direction of a simplified workflow where the pre-heat step and/or wash step are eliminated and where the processing and gumming step are carried out in one single step or where processing is carried out with a neutral gum and then gummed in a second step. Alternatively, on-press processing wherein the plate is mounted on the press and the coating layer is developed by interaction with the fountain and/or ink that are supplied to the plate during the press run, has become very popular. During the first runs of the press, the non-image areas are removed from the support and thereby define the non-printing areas of the plate.

In particular printing plates designed for on-press processing, require lithographic coatings that are sufficiently soluble or dispersible on the press so that a good clean-out (complete removal of the coating at non-printing areas of the image) is obtained. Moreover, apart from the clean-out behaviour, also the presslife of such printing plates should be optimized. Both presslife and clean-out performance are determined by the interaction between the coating and the substrate: an optimal presslife requires sufficient adhesion between the substrate and the coating in the image areas, while a good clean-out requires minimal interaction of the coating with the substrate in the non-image areas upon processing. Thus maximizing the clean-out performance may result in reduced image adhesion and consequently in a reduced press life.

Therefore, in the art there have been several technological developments, trying to solve these issues. In several approaches, reactive interlayers or sublayers and/or support treatments have been designed to optimize the lithographic contrast by increasing the hydrophobicity and/or adhesion at the image-areas, while remaining or increasing the hydrophilicity at the non-image areas.

Often a compound for improving the adhesion between the photopolymer coating and the support is added to the printing plate precursor for increasing the resistance of the exposed areas during the processing step and for improving the durability of the plate in the printing process as disclosed in EP 851 299, EP 1 091 251, EP 1 495 866, EP 1 500 498 and EP 1 520 694. Typically, these compounds have an ethylenically unsaturated bond and a functional group capable of adsorbing to the surface of the support and can be present in the photopolymerisble layer or in an intermediate layer between the support and the photopolymerisable layer.

However, as such hydrophilic binders are typically soluble and/or dispersable in fountain solutions used during the on press development, accumulation of such binder materials in the fountain solution may lead to pollution of the fountain solution and/or deposits or fouling of the printing press. Moreover, such a contamination of the fountain solution may alter the ink-water balance during printing leading to printing failures such as image "blinding" (ink fails to attach to the image areas) or "scumming" (ink attaches to the non-image areas), or both.

EP 1 880 978 discloses silica particles modified with an organic compound having an ethylenically unsaturated group, a hydrophilic moiety and a silyloxy group.

US 2011/076618 discloses a printing plate precursor including a coating including an inorganic particle such as a silica particle or mica which contains an acrylic polymer as a graft chain.

EP 1 587 691 discloses silicate coated polymer particles and the preparation thereof.

EP1 495 864 discloses a printing plate precursor including an infrared absorbing agent, an acid or radical generator, a polymerisable compound and a filler such as metal oxides, metal hydroxides, metal carbonates, metal sulfates, metal silicates metal nitrides and internally cross-linked organic particles.

JP2007/ discloses a printing plate precursor including a substrate, a hydrophilic layer containing a photothermal conversion agent and an imaging layer containing polymeric fine particles including a silanol group.

US 6,899,994 discloses that using binders in particulate form over using non-particulate binders tends to promote the developability of the unexposed non image areas combined with an enhanced durability of the exposed image areas.

US 2009/056580, US2008/229957 and US2008/229955 disclose a method to obtain a lithographic printing master comprising a radiation sensitive coating comprising hydrophilic polymer particles and hydrophobic polymer particles which form a hydrophilic layer and which after image-wise exposing to radiation becomes hydrophobic while the unexposed area remains hydrophilic.

EP 1 920 942 discloses a lithographic printing plate precursor having a photosensitive layer containing a hydrophilic polymer, a crosslinking agent, hydrophobic polymer particles and a photo-thermal converter, wherein the hydrophilic polymer does not substantially contain, in its polymer chain, any of alcoholic hydroxyl groups and carboxyl groups.

US 6 949 327 discloses an imageable element including a composition which comprises a photothermal conversion material and particles of a polyurethane polymer including urethane linkages in the main chain prepared by reaction of a diisocyanate and a dihydroxy compound which comprises about 1-25 percent of a carboxy functional diols.

EP 1 481 800 discloses a printing plate precursor comprising a thermally sensitive layer comprising polycyanoacrylate particles having a major dimension between about 50 and about 500 nm and a mean major dimension below 350 nm.

US 9 366 962 discloses a negative-working lithographic printing plate precursor comprising an infrared radiation-sensitive imageable layer including a primary polymeric binder comprising polyalkylene oxide present in the form of particles having an average particle size of at least 50 nm and up to and including 1000 nm; and a secondary resin that is present as particles having an average particle size of at least 3 micron and up to and including 10 micron and wherein the infrared radiation-sensitive imageable layer has a defined average dry thickness.

A printing plate precursor containing a coating which includes a compound containing at least one thiol group and at least one group capable of adhering to the substrate is disclosed in unpublished patent application EP20201023.

EP3815900 discloses a lithographic printing plate precursor including a coating comprising a polymerisable compound, optionally a sensitizer, a photoinitiator and discrete particles, which comprise a crosslinked hydrophobic polymer backbone and a plurality of hydrophobic pendant grafts.

JP2003/118256 discloses a printing plate precursor including a coating comprising hydrophobized resin fine particles, a photothermal conversion agent, and a hydrophilic polymer having a silane coupling end group.

Although many attempts have been made in the art to provide high performing photopolymer printing plates, there is still a need to improve the balance between press durability and clean out behaviour of the non-image areas especially under non-aggressive processing conditions such as processing without the presence of a strong alkaline (pH ≥ 12) solution - i.e. off-press processing with a gum solution or on-press processing with fountain and ink. In addition, contamination of the fountain solution during on press processing remains a concern in the art.

### Summary of invention

It is an object of the present invention to provide a lithographic printing plate precursor which, upon image-wise exposure and processing on-press with fountain solution and/or ink, exhibits an improved clean out behaviour combined with an excellent resistance of the imaged areas on press.

This object is realised by the printing plate precursor defined in claim 1 with preferred embodiments defined in the dependent claims. The printing plate precursor of the present invention has the specific feature that it contains a coating comprising a polymerisable compound, optionally a sensitizer, a photoinitiator and discrete particles comprising a plurality of silane groups, and/or silanol groups and/or siloxane reaction products of said silane and/or silanol groups.

According to the current invention, it was found that by incorporating said discrete particles in the coating, a highly improved clean-out behaviour combined with an excellent resistance of the imaged areas on press was obtained. An insufficient clean-out means that, after processing, the non-image areas are not completely removed from the support or that the compounds remaining on the support in the non-image areas are too hydrophobic and, as a result, the hydrophilic property of the surface of the support is reduced. An insufficient clean-out may result in toning on the press, i.e. an undesirable increased tendency of ink-acceptance in the non-image areas of the prints.

During the on-press processing step the plate precursor is mounted on the plate cylinder of the printing press and the non-exposed areas of the coating are removed by rotating the plate cylinder while feeding dampening liquid and/or ink to the coating. It is believed that during the on-press processing step the particles according to the present invention are, at least partially, removed by the oily ink and/or on printed sheets during the first rotations of the printing press. As a result, the aqueous fountain solution may become less contaminated.

It is a further object of the present invention to provide a method for making a lithographic printing plate comprising the steps of:
- image-wise exposing the printing plate precursor including the coating as defined above to heat and/or IR radiation whereby a lithographic image consisting of image areas and non-image areas is formed;
- developing the exposed precursor.

Other features, elements, steps, characteristics and advantages of the present invention will become more apparent from the following detailed description of preferred embodiments of the present invention. Specific embodiments of the invention are also defined in the dependent claims.

### Description of embodiments

The lithographic printing plate precursor

The lithographic printing plate precursor of the present invention comprises a support, preferably a support having a hydrophilic surface or which is provided with a hydrophilic layer, and a coating including a photopolymerisable layer. The lithographic printing plate precursor is negative-working, i.e. after exposure and development the non-exposed areas of the coating are removed from the support and define hydrophilic (non-printing) areas, whereas the exposed coating is not removed from the support and defines oleophilic (printing) areas. The hydrophilic areas are defined by the support which has a hydrophilic surface or is provided with a hydrophilic layer. The hydrophobic areas are defined by the coating, hardened upon exposing, optionally followed by a heating step. Areas having hydrophilic properties means areas having a higher affinity for an aqueous solution than for an oleophilic ink; areas having hydrophobic properties means areas having a higher affinity for an oleophilic ink than for an aqueous solution.

"Hardened" means that the coating becomes insoluble or non-dispersible for the developing solution and may be achieved through polymerization and/or crosslinking of the photosensitive coating, optionally followed by a heating step to enhance or to speed-up the polymerization and/or crosslinking reaction. In this optional heating step, hereinafter also referred to as "pre-heat", the plate precursor is heated, preferably at a temperature of about 80°C to 150°C and preferably during a dwell time of about 5 seconds to 1 minute.

The coating includes at least one layer including a photopolymerisable composition, also referred to as the "photopolymerisable layer". The coating may further include a toplayer provided on top of the photopolymerisable layer. The coating may further include other layers such as for example an intermediate layer, located between the support and the photopolymerisable layer and/or between the optional top layer and the photopolymerisable layer, an adhesion improving layer and/or other layers.

The coating of the printing plate precursor is most preferably capable of being developed on-press with dampening liquid and/or ink.

The photopolymerisable layer includes at least one polymerisable compound, the discrete particles, an initiator, optionally a sensitizer and optionally a further binder. The photopolymerisable layer has a coating thickness preferably ranging between 0.2 and 5.0 g/m², more preferably between 0.4 and 3.0 g/m², most preferably between 0.6 and 2.2 g/m².

### Discrete particles

The coating of the lithographic printing plate precursor of the present invention includes a polymeric binder in the form of discrete particles - also referred to herein as "discrete particles" or "particulate resin binder" or "particulate binder". The particulate binder may be a homopolymer or a copolymer, preferably the particulate binder is a copolymer. The copolymer can be a random copolymer, an alternating copolymer or a block copolymer. The term "copolymer" refers to a polymer that includes at least two different monomeric units and the term "polymer" refers to high and low molecular weight polymers including oligomers. The discrete particles comprise a plurality of silane groups, silanol groups and/or siloxane reaction products of said silane and/or silanol groups. The discrete particles are at least present in the photopolymerisable layer and are preferably uniformly distributed throughout this layer.

The discrete particles preferably exist at room temperature as discrete particles, for example in an aqueous dispersion or emulsion. The particulate resin binders generally have a weight average molecular weight (Mw) of at least 5,000 and typically at least 20,000 or at least 30,000 and up to and including 300,000,000 as determined by Gel Permeation Chromatography (GPC) whereby the molecular weights are correlated to polystyrene standards. Depending on the type of the discrete particles - e.g. degree of crosslinking, a limited solubility in for example the eluent used in the GPC determination may impede the molecular weight determination.

Preferably, these discrete particles have a particle size of at least 10 nm upto and including 1000 nm, more preferably a particle size of at least 15 nm upto and including 500 nm, most preferably a particle size of at least 20 nm upto and including 150 nm. The size of the discrete particles is preferable adjusted to the coating thickness, i.e. the discrete particles preferably have a diameter which is smaller than the thickness of the coating such as for example about 20 to 25 nm. The particle size refers to the z-average particle size and may be measured - as described in the Examples - by a laser diffraction particle analyzer such as Malvern Zetasizer Nano S.

The discrete particles include repeating units derived from the monomers selected from alkylmethacrylates, alkylacrylates, acrylamides, methacrylamides, vinylesters, vinylacetamides and/or repeating units comprising a segment including urethanes and/or a polyurea and/or combinations thereof.

The repeating units derived from the monomers selected from alkylacrylates, alkylmethacrylates, acrylamides, methacrylamides, vinylesters or vinylacetamides are preferably represented by the following structures: 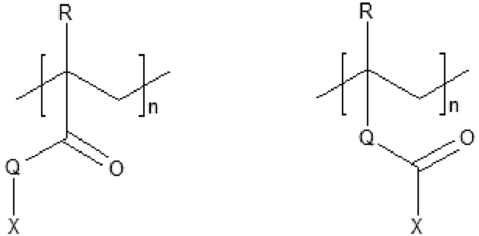 wherein
R represents hydrogen or a methyl group;
Q represents O or NH;
X represents an optionally substituted alkyl group, and
n represents an integer greater than zero, preferably n represents an integer between 2 and 300, more preferably between 5 and 200, most preferably between 30 and 150.

Preferably X represents an optionally substituted straight, branched, cyclic or alicyclic alkyl group having 1-20 carbon atoms, more preferably having 2-10 carbon atoms and most preferably 3-8 carbon atoms. Suitable alkyl groups include a methyl, ethyl, propyl, isopropyl, butyl, tertiary butyl, pentyl, cyclopentyl, cyclohexyl or adamantyl group alkyl.

The discrete particles preferably contain repeating units derived from the monomers selected from methylmethacrylate, ethylmethacrylate, propyl methacrylate, butylmethacrylate, allylmethacrylate, 2-ethylhexylmethacrylate, cyclohexylmethacrylate, methylacrylate, ethylacrylate, propylacrylate, butylacrylate, allylacrylate, 2-ethylhexylacrylate and cyclohexylacrylate, acrylamides such as N-alkylacrylamides, methacrylamides such as N-alkylmethacrylamides; and/or combinations thereof.

More preferably, the discrete particles contain repeating units selected from alkylacrylates and/or alkylmethacrylates wherein the alkyl group has three or more than three carbon atoms such as propylmethacrylate, butylmethacrylate, propylacrylate or butylacrylate. Most preferably, the particulate binder contains repeating units selected from alkylacrylates and/or alkylmethacrylates wherein the alkyl group has more than three carbon atoms such as butylmethacrylate or butylacrylate.

The hydrophobicity of the discrete particles can be modified by the selection of specific monomeric units. For example, discrete particles including mainly butyl(meth)acrylate give a substantial better ink uptake compared to discrete particles including mainly methyl(meth)acrylate. The hydrophobicity of the discrete particles is preferably optimised in order to maximize the ink uptake while maintaining sufficient clean out behaviour.

The plurality of silane groups and/or silanol groups groups and/or siloxane reaction products of said silane and/or silanol groups may be directly attached to the discrete particles with a carbon/silicium bond, or more preferably through a linking group. Suitable linking groups are for example optionally substituted straight-chain or branched C₁-C₁₂-alkanediyl group, more preferably a C₂-C₁₂-alkanediyl group, most preferably a C₃-C₁₂-alkanediyl group, preferably optionally interrupted by one or more nitrogen atoms, oxygen atoms, carbonyl groups and/or carboxyl groups. The optional substituents on the straight-chain or branched alkanediyl group are for example an alkyl group such as a methyl or ethyl group or a hydroxy group and/or combinations thereof.

The silane groups, silanol groups and/or siloxane reaction products of said silane and/or silanol groups may cause crosslinking of the discrete particles. Crosslinking may avoid both film formation upon coating and/or solubilisation of the discrete particles in the coating solvent. For example, silicium based crosslinks might be formed by for example hydrolysation and/or subsequent condensation of the silane groups, silanol groups and/or siloxane reaction products of said silane and/or silanol groups whereby Si-O-Si bonds may be formed.

The silane groups, silanol groups and/or siloxane reaction products of said silane and/or silanol groups show a good adhesion (also referred to herein as "interaction") to the support, preferably an aluminum support, whereby a printing plate precursor with a good press life is obtained. In addition, according to the present invention it was observed that the further presence of unmodified silicium oxide particles - i.e. silica particles having surface hydroxyl groups - and/or metal oxides/metal hydroxide particles, provide an improved cohesion strength whereby the image areas become even more robust in view of press life (i.e. improved run length) and/or plate handling. Most preferred are silica particles having surface hydroxyl groups. These silica particles are preferably present in an amount of 1 to 40 % by weight, more preferably 2 to 35 % by weight and most preferably 5 to 30 % by weight, relative to the total weight of the ingredients of the coating.

Preferred metal oxides or metal hydroxide particles include alkali metal oxides or alkaline earth metal oxides such as Li₂O, Na₂O, K₂O, MgO, Mg(OH)₂, CaO, Ca(OH)₂ and/or TiO₂; ZnO, Al(OH)₃, Al₂O₃ and/or AIOOH.

The content of the silane groups, silanol groups and/or siloxane reaction products of said silane and/or silanol groups in the discrete particles is preferably higher than 2 wt% by weight, more preferably higher than 5 wt% by weight and most preferably equal to or higher than 10 wt% by weight and preferably below 25% by weight. Copolymers containing not more than 25% of silane groups, silanol groups and/or siloxane reaction products of said silane and/or silanol groups are preferred due to their colloidal stability in water and/or in coating solutions. In addition, a too high level of silane groups, silanol groups and/or siloxane reaction products of said silane and/or silanol groups may lead to highly crosslinked particles whereby the adhesion properties of the particles to the support may be deteriorated. Indeed, a rigid polymer particle (i.e. a highly crosslinked particle including for example more than 40 wt% by weight silane groups, silanol groups and/or siloxane reaction products of said silane and/or silanol groups) do not or very limited interact with the substrate; although upon imaging, thermal deformation and/or softening of the particles in the imaged areas may occur whereby a better interaction (i.e. adhesion) with the substrate may be obtained.

Under "interacting" is understood each type of physical and/or chemical reaction or process whereby, between the silicium based group and the support, a bond is formed which can be a covalent bond, an ionic bond, a complex bond, a coordinate bond or a hydrogen-bridge bond, and which can be formed by an adsorption process, a chemical reaction, an acid-base reaction, a complex-forming reaction or a reaction of a chelating group or a ligand.

The glass transition temperature of the discrete particles, if present, is preferably above 5 °C; the glass transition temperature may be influenced by the degree of crosslinking. However, the glass transition temperature of copolymers including more than 25% by weight silane groups, silanol groups and/or siloxane reaction products of said silane and/or silanol groups and thus having a relative high crosslinking degree, might be difficult to determine. The glass transition temperature can be calculated/estimated using the Fox Equation (i.e. excluding the silane monomers) as described in "Handbook of Polymer Blends and Composites" by C. Vasile and A.K. Kulshereshtha, 2003, Volume 3B page 392.

The processability of the coating may be influenced by the swellability of the photolayer during processing, and according to the present invention it was found that the coating comprising the discrete particles according to the present invention exhibits an improved clean out behaviour. Without being limited to any theoretical explanation and/or hypothesis, it is believed that the plurality of silane and/or silanol groups and/or siloxane derivatives thereof at least partially hydrolyse during the processing step of the printing plate precursor and form soluble products whereby its processing behaviour is improved.

The discrete particles preferably include repeating units derived from alkoxy silane containing monomers such as for example dialkoxy silanes and/or trialkoxysilanes and/or combinations thereof. The discrete particles preferably include at least 2 wt% by weight repeating units derived from alkoxy silane containing monomer, more preferably at least 5 wt% by weight and most preferably equal to or higher than 10 wt% by weight and preferably below 25% by weight.

Optionally, di(meth)acrylates may be included in the polymeric binder.

Suitable examples of such alkoxy silane containing monomers are e.g. alkoxy silane based monomers such as 3-(trimethoxysilyl)propyl methacrylate, vinyl trimethoxy silane, acryloxypropyltrimethoxysilane, methacryloxypropyltriethoxysilane, 3-acryloxypropyltriethoxysilane, methacryloxypropyltriisopropoxysilane, methacryloxymethyl)trimethoxysilane, methacryloyloxymethyltriethoxysilane, [tris(2-methoxyethoxy)silyl]propyl 2-methyl-2-propenoate , 4-oxo-4-[[3-(triethoxysilyl)propyl]amino]-2-butenoic acid, 2-Methyl-N-[3-(triethoxysilyl)propyl]-2-propenamide, N-[3-(trimethoxysilyl)propyl]-2-propenamide, (3-acryloxypropyl)methyldimethoxysilane, 3-(diethoxymethylsilyl)propyl 2-propenoate, 2-propenoic acid, (dimethoxymethylsilyl)methyl ester, vinyltriethoxysilane, vinylmethyldimethoxysilane, vinyltriisopropoxysilane, vinylmethyldiethoxysilane, 1,3-diethenyl-1,1,3,3-tetraethoxydisiloxane, (ethenyldiethoxysilyl)benzene , 3-(trimethoxysilyl)-2-propen-1-yl 2-methyl-2-propenoate, 1,3-diethenyl-1,1,3,3-tetramethoxy-disiloxane, 1-ethenyl-4-(trimethoxysilyl)benzene, 1-ethenyl-4-(triethoxysilyl)benzene, 1-(Diethoxymethylsilyl)-4-ethenylbenzene, N-(3-Acryloxy-2-hydroxypropyl)-3-aminopropyltriethoxysilane, 1-[3-(triethoxysilyl)propyl]-1H-pyrrole-2,5-dione, (2Z)-4-oxo-4-[[3-(triethoxysilyl)propyl]amino]-2-butenoic acid, N-2-Propen-1-yl-N-[3-(triethoxysilyl)propyl]-2-propen-1-amine, 4-oxo-4-[[3-(triethoxysilyl)propyl]amino]-2-butenoic acid, 2-propenoic acid, 4-[[3-(trimethoxysilyl)propyl]amino]butyl ester, 2-propenoic acid, 9,9-diethoxy-4-oxo-3,10-dioxa-5-aza-9-siladodec-1-yl ester, (2Z)-4-[[3-(diethoxymethylsilyl)propyl]amino]-4-oxo-2-butenoic acid.

The discrete particles can be prepared by several methods. Below, as an example, suitable preparation techniques are summarized.

The discrete particles according to the present invention are preferably prepared by radical copolymerization of alkoxy silane based monomers during preparation of the discrete particles e.g. (meth)acrylic particles. In particular emulsion copolymerization can be a suitable method, but also mini-emulsion polymerization can be used.

Apart from radical copolymerization, the discrete particles can be obtained by condensation polymerization. For example, dispersions of polyurethanes modified with alkoxy silane groups. Such dispersions are commercially available from for example Mitsui under the tradename TAKELAC WS grades.

As an alternative to in-situ preparation of the discrete particles, alkoxysilane modified polymers can be dispersed in water using various dispersion techniques. For example by the so call Perutz dispersion technique where the alkoxysilane modified polymer is dissolved in a water immiscible solvent e.g. ethylacetate, and added to an aqueous solution including a surfactant or stabilizer; after a high shear treatment the ethylacetate is evaporated and a polymer particle dispersion is obtained.

The discrete particles may be present in the photopolymerizable layer, and/or in the optional toplayer, and/or in any other optional layer such as for example an intermediate layer located between the support and the photopolymerisable layer, an adhesion improving layer, a hydrophilizing layer and/or other layers. Most preferably, the discrete particles are present in the photopolymerizable layer.

The discrete particles may be present in the coating in an amount comprised between 1 and 50 wt%, preferably between 3 and 30 wt%, more preferably between 5 and 20 wt% of the non-volatile components of the coating composition.

### Binders

The negative-working photosensitive composition may further include polymeric binders that are substantially not crosslinkable and are film-forming in nature. Such binders are preferably soluble in the coating solvent and can be selected from a wide series of organic polymers. Compositions of different binders can also be used. Useful binders are described in for example EP 1 043 627 in paragraph [0013].

### Polymerisable compound

According to a preferred embodiment of the present invention, the polymerisable compound is a polymerisable monomer or oligomer including at least one terminal ethylenic unsaturated group, hereinafter also referred to as "free-radical polymerisable monomer". The polymerisation involves the linking together of the free-radical polymerisable monomers. Suitable free-radical polymerisable monomers include, for example, multifunctional (meth)acrylate monomers (such as (meth)acrylate esters of ethylene glycol, trimethylolpropane, pentaerythritol, ethylene glycol, ethoxylated trimethylolpropane, urethane (meth)acrylate) and oligomeric amine di(meth)acrylates. The (meth)acrylic monomers may also have other ethylenically unsaturated groups or epoxide groups in addition to the (meth)acrylate group. The (meth)acrylate monomers may also contain an acidic (such as a carboxylic acid or phosphoric acid) or basic (such as an amine) functionality.

Suitable free-radical polymerisable monomers are disclosed in [0042] and [0050] of EP 2 916 171.

### The initiator

Any free radical initiator capable of generating free radicals upon exposure directly or in the presence of a sensitizer, is according to this invention a suitable initiator. Suitable examples of initiators include onium salts, carbon-halogen bond-containing compounds such as [1,3,5] triazines having trihalomethyl groups, organic peroxides, aromatic ketones, thio compounds, azo based polymerization initiators, azide compounds, ketooxime esters, hexaarylbisimidazoles, metallocenes, active ester compounds, borates and quinonediazides. Of these, onium salts, especially iodonium and/or sulfonium salts are preferable in view of storage stability.

More specific suitable free-radical initiators include, for example, the derivatives of acetophenone (such as 2,2-dimethoxy-2-phenylacetophenone, and 2-methyl-I-[4-(methylthio) phenyll-2-morpholino propan-I-one); benzophenone; benzil; ketocoumarin (such as 3-benzoyl-7-methoxy coumarin and 7-methoxy coumarin); xanthone; thioxanthone; benzoin or an alkyl-substituted anthraquinone; onium salts (such as diaryliodonium hexafluoroantimonate, diaryliodonium triflate, (4-(2-hydroxytetradecyl-oxy)-phenyl) phenyliodonium hexafluoroantimonate, triarylsulfonium hexafluorophosphate, triarylsulfonium p-toluenesulfonate, (3-phenylpropan-2-onyl) triaryl phosphonium hexafluoroantimonate, and N-ethoxy(2-methyl)pyridinium hexafluorophosphate, and onium salts as described in U.S. Pat.Nos. 5,955,238,6,037,098, and 5,629,354); borate salts (such as tetrabutylammonium triphenyl(n-butyl)borate, tetraethylammonium triphenyl(n-butyl)borate, diphenyliodonium tetraphenylborate, diphenyliodonium tetraphenylborate wherein the phenyl groups of the iodonium salt are substituted with a group including at least six carbon atoms, and triphenylsulfonium triphenyl(n-butyl)borate, and borate salts as described in U.S. Pat. Nos. 6,232,038 and 6,218,076,); haloalkyl substituted s-triazines (such as 2,4-bis(trichloromethyl)-6-(p-methoxy-styryl)-s-triazine, 2,4-bis(trichloromethyl)-6-(4-methoxy-naphth-I-yl)-s-triazine, 2,4-bis(trichloromethyl)-6-piperonyl-s- triazine, and 2,4-bis(trichloromethyl)-6-[(4-ethoxy-ethylenoxy)-phen-1-yl]-s-triazine, and s-triazines as described in U.S. Pat. Nos. 5,955,238, 6,037,098, 6,010,824 and 5,629,354); and titanocene (bis(etha.9-2,4-cyclopentadien-1-yl) bis[2,6-difluoro-3-(IH-pyrrol-1-yl)phenyl) titanium). Onium salts, borate salts, and s-triazines are preferred free radical initiators. Diaryliodonium salts and triarylsulfonium salts are preferred onium salts. Triarylalkylborate salts are preferred borate salts. Trichloromethyl substituted s-triazines are preferred s-triazines. These initiators may be used alone or in combination.

Optionally substituted trihaloalkyl sulfones wherein halo independently represents bromo, chloro or iodo and sulfone is a chemical compound containing a sulfonyl functional group attached to two carbon atoms, are particularly preferred initiators. Tribromomethyl phenyl sulfones are most preferred initiators. More details concerning this initiator can be found in WO 2019/179995 paragraphs [0029] to [0040].

The amount of the initiator typically ranges from 0.1 to 30 % by weight, preferably from 0.5 to 15 % by weight, most preferably from 2 to 10 % by weight relative to the total dry weight of the components of the photopolymerisable composition.

The photopolymerisable layer may also comprise a co-initiator. Typically, a co-initiator is used in combination with a free radical initiator. Suitable co-initiators for use in the photopolymer coating are disclosed in US 6,410,205; US 5,049,479; EP 1 079 276, EP 1 369 232, EP 1 369 231, EP 1 341 040, US 2003/0124460, EP 1 241 002, EP 1 288 720 and in the reference book including the cited refences: Chemistry & Technology UV & EB formulation for coatings, inks & paints - Volume 3 -Photoinitiators for Free Radical and Cationic Polymerisation by K.K. Dietliker - Edited by P.K.T. Oldring - 1991 - ISBN 0 947798161. Specific co-initiators, as described in EP 107 792, may be present in the photopolymerizable layer to further increase the sensitivity. Preferred co-initiators are disclosed in EP 2 916 171 [0051].

Specific co-initiators, as described in EP 107 792, may be present in the photopolymerizable layer to further increase the sensitivity. Preferred co-initiators are sulfur-compounds, especially thiols like e.g. 2-mercaptobenzothiazole, 2-mercaptobenzoxazole, 2-mercaptobenzimidazole, 4-methyl-3-propyl-1,2,4-triazoline-5-thione, 4-methyl-3-n-heptyl-1,2,4-triazoline-5-thione, 4-phenyl-3-n-heptyl-1,2,4-triazoline-5-thione, 4-phenyl-3,5-dimercapto-1,2,4-triazole, 4-n-decyl-3,5-dimercapto-1,2,4-triazole, 5-phenyl-2-mercapto-1,3,4-oxadiazole, 5-methylthio-1,3,4-thiadiazoline-2-thione, 5-hexylthio-1,3,4-thiadiazoline-2-thione, mercaptophenyltetrazole, pentaerythritol mercaptopropionate, butyric acid-3-mercapto-neopentanetetrayl ester, pentaerythritol tetra(thioglycolate). Other preferred co-initiators are polythioles as disclosed in WO 2006/048443 and WO 2006/048445. These polythiols may be used in combination with the above described thiols, e.g. 2-mercaptobenzothiazole.

### Sensitizer

The photopolymerisable layer preferably includes a sensitizer which is capable of absorbing light used in the image-wise exposing step. A sensitizer which absorbs light between 750 nm and 1300 nm, preferably between 780 nm and 1200 nm, more preferably between 800 nm and 1100 nm may be used. Particular preferred sensitizers are heptamethinecyanine dyes such as for example disclosed in EP 1 359 008. Other preferred sensitizers are violet light absorbing sensitizers having an absorption spectrum between 350 nm and 450 nm such as disclosed in EP 1 349 006 paragraph [0007] to [0009], EP 1 668 417 and WO 2004/047930. Other preferred sensitizers are or blue, green or red light absorbing sensitizers, having an absorption spectrum between 450 nm and 750 nm. Useful sensitizers can be selected from the sensitizing dyes disclosed in US 6,410,205; US 5,049,479; EP 1 079 276, EP 1 369 232, EP 1 349 006, EP 1 668 417, WO 2004/047930, EP 1 369 231, EP 1 341 040, US 2003/0124460, EP 1 241 002 and EP 1 288 720. Optionally, an optical brightener may be added to the coating. Suitable examples thereof are described in WO 2005/109103 page 24, line 20 to page 39.

### Toplayer

The coating preferably includes a toplayer or protective overcoat layer which preferably acts as an oxygen barrier layer. Low molecular weight substances present in the air may deteriorate or even inhibit image formation and therefore a toplayer is applied to the coating. A toplayer should preferably be easily removable during development, adhere sufficiently to the photopolymerisable layer or optional other layers of the coating and should preferably not inhibit the transmission of light during exposure. The toplayer is provided on top of the photopolymerisable layer.

The toplayer preferably includes an infrared absorbing compound which is capable of forming a coloured compound - whereby a print-out image is formed - upon exposure to infrared light and/or heat. The infrared absorbing compound is preferably an infrared absorbing dye, also referred to as IR dye. The contrast of the print-out image may be defined as the difference between the optical density at the exposed area and the optical density at the non-exposed area, and is preferably as high as possible. This enables the end-user to establish immediately whether or not the precursor has already been exposed and processed, to distinguish the different color selections and to inspect the quality of the image on the plate precursor. More information regarding such IR dyes can be found in in EP 1 910 082 pages 4 to 8, IRD-001 to IRD-101.

The toplayer may further include a binder. Preferred binders which can be used in the toplayer are polyvinyl alcohol. The polyvinylalcohol has preferably a hydrolysis degree ranging between 74 mol % and 99 mol %, more preferably between 80-98%. The weight average molecular weight of the polyvinylalcohol can be measured by the viscosity of an aqueous solution, 4 % by weight, at 20°C as defined in DIN 53 015, and this viscosity number ranges preferably between 2 and 30, more preferably between 2 and 15, most preferably between 2 and 10.

The toplayer preferably includes a hydrophobic binder including a monomeric unit derived from a vinyl monomer and/or a vinylidene monomer which comprises a halogen such as chloride or fluoride as described in EP 3 587 113.

The overcoat layer may optionally include other ingredients such as inorganic or organic acids, matting agents, surfactants, (organic) waxes or wetting agents as disclosed in EP 2 916 171.

The coating thickness of the toplayer is between 0.10 and 1.75 g/m², more preferably between 0.20 and 1.3 g/m², most preferably between 0.25 and 1.0 g/m². In a more preferred embodiment of the present invention, the toplayer has a coating thickness between 0.25 and 1.75 g/m² and comprises a polyvinylalcohol having a hydrolysis degree ranging between 74 mol % and 99 mol % and a viscosity number as defined above ranging between 3 and 30.

The hydrophilic polymers in the protective overcoat layer may result in a problematic viscosity increase of press chemicals such as for example fountain solution and/or developer solution. Therefore, the thickness of the protective overcoat layer should preferably not be too high e.g. above the ranges as given above.

### Support

The lithographic printing plate used in the present invention comprises a support which has a hydrophilic surface or which is provided with a hydrophilic layer. The support is preferably a grained and anodized aluminium support, well known in the art. Suitable supports are for example disclosed in EP 1 843 203 (paragraphs [0066] to [0075]). The surface roughness, obtained after the graining step, is often expressed as arithmetical mean center-line roughness Ra (ISO 4287/1 or DIN 4762) and may vary between 0.05 and 1.5 µm. The aluminum substrate of the current invention has preferably an Ra value between 0.1 and 1.4 µm, more preferably between 0.3 and 1.0 µm and most preferably between 0.4 and 0.9 µm. The lower limit of the Ra value is preferably about 0.1 µm. More details concerning the preferred Ra values of the surface of the grained and anodized aluminum support are described in EP 1 356 926. By anodising the aluminum support, an Al₂O₃ layer is formed and the anodic weight (g/m² Al₂O₃ formed on the aluminum surface) varies between 1 and 8 g/m². The anodic weight is preferably ≥ 2.0 g/m², more preferably ≥ 2.5 g/m² and most preferably ≥ 3.0 g/m²

The grained and anodized aluminium support may be subjected to so-called post-anodic treatments, for example a treatment with polyvinylphosphonic acid or derivatives thereof, a treatment with polyacrylic acid or derivatives thereof, a treatment with potassium fluorozirconate or a phosphate, a treatment with an alkali metal silicate, or combinations thereof. Enlargement or sealing of micropores of the amodized aluminum as disclosed in JP2001-253181A or JP2001-322365A may be performed. Alternatively, the support may be treated with an adhesion promoting compound such as those described in EP 1 788 434 in [0010] and in WO 2013/182328. However, for a precursor optimized to be used without a pre-heat step it is preferred to use a grained and anodized aluminium support without any post-anodic treatment.

Besides an aluminium support, a plastic support, for example a polyester support, provided with one or more hydrophilic layers as disclosed in for example EP 1 025 992 may also be used.

### Other ingredients

The lithographic printing plate precursor of the present invention further preferably includes one or more polymeric binders or (co)polymers that preferably facilitate the developability of the coating.

The photopolymerisable layer may also comprise particles which increase the resistance of the coating against manual or mechanical damage. The particles may be inorganic particles, organic particles or fillers such as described in for example US 7,108,956. More details of suitable spacer particles described in EP 2 916 171 [0053] to [0056]. The thickness of spacer particles is typically higher than the coating thickness.

The photopolymerizable layer may also comprise an inhibitor. Particular inhibitors for use in the photopolymer coating are disclosed in US 6,410,205, EP 1 288 720 and EP 1 749240.

The photopolymerizable layer may further comprise an adhesion promoting compound. The adhesion promoting compound is a compound capable of interacting with the support, preferably a compound having an addition-polymerizable ethylenically unsaturated bond and a functional group capable of interacting with the support. Suitable adhesion promoting compounds are described in EP 2 916 171 [0058].

Various surfactants may be added into the photopolymerisable layer to allow or enhance the developability of the precursor; especially developing with a gum solution. Both polymeric and small molecule surfactants for example nonionic surfactants are preferred. More details are described in EP 2 916 171 [0059].

Organic wax particles as described in for example US 8,679,726 and US 9,063,423 which improve scratch resistance may also be added to the photopolymerisable layer.

The lithographic printing plate precursor can be prepared by (i) applying on a support the coating as described above and (ii) drying the precursor.

### Definitions

The term "(co)polymer" in the context of the present invention refers to high molecular weight homopolymers and/or copolymers. The term "copolymer" refers to polymers that are derived from two or more different monomers. The term "backbone" in the context of the present invention refers to the chain of atoms in a polymer to which a plurality of pendant groups are attached. An example of such a backbone is an "all carbon" backbone obtained from the polymerization of an ethylenically unsaturated monomer.

The term repeating unit is a part of a polymer whose repetition can produce a polymer chain (except for the end-groups) by linking the repeating units together successively along the chain.

The term "silane" refers to a functional group including hydrogen and silicon that have the general formula SiₙH₂ₙ₊₁ wherein n is an integer greater than 0.

The term "silanol" refers to a functional group including at least one Si-O-H group.

The term "siloxane" refers to a functional group with a Si-O-Si linkage or -(OSiH₂)ₙ- linkage such as for example -(OSiH₂)ₙOH wherein n is an integer greater than 0.

The term "alkyl" herein means all variants possible for each number of carbon atoms in the alkyl group i.e. methyl, ethyl, for three carbon atoms: n-propyl and isopropyl; for four carbon atoms: n-butyl, isobutyl and tertiary-butyl; for five carbon atoms: n-pentyl, 1,1-dimethyl-propyl, 2,2-dimethylpropyl and 2-methyl-butyl, etc. Examples of suitable alkyl groups are methyl, ethyl, n-propyl, isopropyl, n-butyl, 1-isobutyl, 2-isobutyl and tertiary-butyl, n-pentyl, n-hexyl, chloromethyl, trichloromethyl, iso-propyl, iso-butyl, iso-pentyl, neo-pentyl, 1-methylbutyl and iso-hexyl, 1,1-dimethyl-propyl, 2,2-dimethylpropyl and 2-methyl-butyl, cyclopropyl, cyclobutyl, cyclopentyl, cyclohexyl and methylcyclohexyl groups. Preferably, the alkyl group is a C₁ to C₆-alkyl group.

The term "aryl" herein means aryl, aralkyl, cycloaryl, heteroaryl or cycloheteroaryl. Suitable aryl groups include for example phenyl, naphthyl, benzyl, tolyl, ortho- meta- or para-xylyl, anthracenyl or phenanthrenyl. Suitable aralkyl groups include for example phenyl groups or naphthyl groups including one, two, three or more C₁ to C₆-alkyl groups. Suitable heteroaryl groups are preferably monocyclic- or polycyclic aromatic rings comprising carbon atoms and one or more heteroatoms in the ring structure. Preferably 1 to 4 heteroatoms are independently selected from nitrogen, oxygen, selenium and sulphur and/or combinations thereof. Examples include pyridyl, pyrimidyl, pyrazoyl, triazinyl, imidazolyl, (1,2,3,)- and (1,2,4)-triazolyl, tetrazolyl, furyl, thienyl, isoxazolyl, thiazolyl and carbazoyl. A cyclic group or cyclic structure includes at least one ring structure and may be a monocyclic- or polycyclic group, meaning one or more rings fused together.

Halogens are selected from fluorine, chlorine, bromine or iodine.

The term "substituted", in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms.

Optional substituents are preferably selected from -Cl, -Br, -I, -OH, -SH, - CN, -NO₂, an alkyl group such as a methyl or ethyl group, an alkoxy group such as a methoxy or an ethoxy group, an aryloxy group, a carboxylic acid group or an alkyl ester thereof, a sulphonic acid group or an alkyl ester thereof, a phosphonic acid group or an alkyl ester thereof, a phosphoric acid group or an an ester such as an alkyl ester such as methyl ester or ethyl ester, a thioalkyl group, a thioaryl group, thioheteroaryl, -SH, a thioether such as a thioalkyl or thioaryl, ketone, aldehyde, sulfoxide, sulfone, sulfonate ester, sulphonamide, an amino, ethenyl, alkenyl, alkynyl, cycloalkyl, alkaryl, aralkyl, aryl, heteroaryl or heteroalicyclic group and/or combinations thereof.

Room temperature refers typically to about 18°C to 25°C.

### Exposure step

The printing plate precursor is preferably image-wise exposed by heat and/or a laser emitting light; UV or IR light. Preferably, the image-wise exposing step is carried out off-press in a platesetter, i.e. an exposure apparatus suitable for image-wise exposing the precursor with a laser such as a laser diode, emitting around 830 nm or a Nd YAG laser emitting around 1060 nm, a violet laser, emitting around 400 nm, or a gas laser such as an Ar laser. Preferably, the precursor is image-wise exposed by a laser emitting IR-light (i.e. wavelengths ranging between 750 and 1500 nm) or violet light (i.e. wavelengths ranging between 350 and 450 nm); most preferred by a laser emitting IR-light.

Alternatively, the light source can be a bulb or lamp such as mercury vapour bulbs. The image wise exposure may be achieved by means of modulation of the light emitted from the light source. This modulation can be done by means of digital mirror devices, also called DMD imaging. UV setters which are suitable to digitally modulate the light source are available from Lüscher AG and Basysprint from Xeikon International B.V. The digital information is obtained from a digital image which is made available to the UV setter.

### Preheat step

After the exposing step, the precursor may be pre-heated in a preheating unit, preferably at a temperature of about 80°C to 150°C and preferably during a dwell time of about 5 seconds to 1 minute. This preheating unit may comprise a heating element, preferably an IR-lamp, an UV-lamp, heated air or a heated roll. Such a preheat step can be used for printing plate precursors comprising a photopolymerisable composition to enhance or to speed-up the polymerization and/or crosslinking reaction.

### Development step

Subsequently to the exposing step or the preheat step, when a preheat step is present, the plate precursor may be processed (developed). Before developing the imaged precursor, a pre-rinse step might be carried out especially for the negative-working lithographic printing precursors having a protective oxygen barrier or topcoat. This pre-rinse step can be carried out in a stand-alone apparatus or by manually rinsing the imaged precursor with water or the pre-rinse step can be carried out in a washing unit that is integrated in a processor used for developing the imaged precursor. The washing liquid is preferably water, more preferably tap water. More details concerning the wash step are described in EP 1 788 434 in [0026].

During the development step, the non-exposed areas of the image-recording layer are at least partially removed without essentially removing the exposed areas. The processing liquid, also referred to as developer, can be applied to the plate e.g. by rubbing with an impregnated pad, by dipping, immersing, coating, spincoating, spraying, pouring-on, either by hand or in an automatic processing apparatus. The treatment with a processing liquid may be combined with mechanical rubbing, e.g. by a rotating brush. During the development step, any water-soluble protective layer present is preferably also removed. The development is preferably carried out at temperatures between 20 and 40 °C in automated processing units.

In a highly preferred embodiment, the processing step as described above is replaced by an on-press processing whereby the imaged precursor is mounted on a press and processed on-press by rotating said plate cylinder while feeding dampening liquid and/or ink to the coating of the precursor to remove the unexposed areas from the support. In a preferred embodiment, only dampening liquid is supplied to the plate during start-up of the press and after a number of revolutions of the plate cylinder also the ink supply is switched on. In an alternative embodiment, supply of dampening liquid and ink is started simultaneously, or only ink can be supplied during a number of revolutions before switching on the supply of dampening liquid. After and/or during the processing step, paper can be fed to the printing press.

The processing step may also be performed by combining embodiments described above, e.g. combining development with a processing liquid with development on-press by applying ink and/or fountain.

### Processing liquid

The processing liquid may be an alkaline developer or solvent-based developer. Suitable alkaline developers have been described in US2005/0162505. An alkaline developer is an aqueous solution which has a pH of at least 8, more preferably of at least 11, more typically at least 12, most preferably from 12 to 14. Alkaline developers typically contain alkaline agents to obtain high pH values can be inorganic or organic alkaline agents. The developers can comprise anionic, non-ionic and amphoteric surfactants (up to 3% on the total composition weight); biocides (antimicrobial and/or antifungal agents), antifoaming agents or chelating agents (such as alkali gluconates), and thickening agents (water soluble or water dispersible polyhydroxy compounds such as glycerine or polyethylene glycol).

Preferably, the processing liquid is a gum solution whereby during the development step the non-exposed areas of the photopolymerisable layer are removed from the support and the plate is gummed in a single step. The development with a gum solution has the additional benefit that, due to the remaining gum on the plate in the non-exposed areas, an additional gumming step is not required to protect the surface of the support in the non-printing areas. As a result, the precursor is processed and gummed in one single step which involves a less complex developing apparatus than a developing apparatus comprising a developer tank, a rinsing section and a gumming section. The gumming section may comprise at least one gumming unit or may comprise two or more gumming units. These gumming units may have the configuration of a cascade system, i.e. the gum solution, used in the second gumming unit and present in the second tank, overflows from the second tank to the first tank when gum replenishing solution is added in the second gumming unit or when the gum solution in the second gumming unit is used once-only, i.e. only starting gum solution is used to develop the precursor in this second gumming unit by preferably a spraying or jetting technique. More details concerning such gum development is described in EP1 788 444.

A gum solution is typically an aqueous liquid which comprises one or more surface protective compounds that are capable of protecting the lithographic image of a printing plate against contamination, e.g. by oxidation, fingerprints, fats, oils or dust, or damaging, e.g. by scratches during handling of the plate. Suitable examples of such surface protective compounds are film-forming hydrophilic polymers or surfactants. The layer that remains on the plate after treatment with the gum solution preferably comprises between 0.005 and 20 g/m² of the surface protective compound, more preferably between 0.010 and 10 g/m², most preferably between 0.020 and 5 g/m². More details concerning the surface protective compounds in the gum solution can be found in WO 2007/057348 page 9 line 3 to page 11 line 6. As the developed plate precursor is developed and gummed in one step, there is no need to post-treat the processed plate.

The gum solution preferably has a pH value between 3 and 11, more preferably between 4 and 10, even more preferably between 5 and 9, and most preferably between 6 and 8. A suitable gum solution is described in for example EP 1 342 568 in [0008] to [0022] and WO2005/111727. The gum solution may further comprise an inorganic salt, an anionic surfactant, a wetting agent, a chelate compound, an antiseptic compound, an antifoaming compound and/or an ink receptivity agent and/or combinations thereof. More details about these additional ingredients are described in WO 2007/057348 page 11 line 22 to page 14 line 19.

### Drying and baking step

After the processing step the plate may be dried in a drying unit. In a preferred embodiment the plate is dried by heating the plate in the drying unit which may contain at least one heating element selected from an IR-lamp, an UV-lamp, a heated metal roller or heated air.

After drying the plate can optionally be heated in a baking unit. More details concerning the heating in a baking unit can be found in WO 2007/057348 page 44 line 26 to page 45 line 20.

The printing plate thus obtained can be used for conventional, so-called wet offset printing, in which ink and an aqueous dampening liquid is supplied to the plate. Another suitable printing method uses a so-called single-fluid ink without a dampening liquid. Suitable single-fluid inks have been described in US 4,045,232; US 4,981,517 and US 6,140,392. In a most preferred embodiment, the single-fluid ink comprises an ink phase, also called the hydrophobic or oleophilic phase, and a polyol phase as described in WO 00/32705.

### EXAMPLES

The comparative and inventive particulate particles, Comp-01 to Comp-05 and Inv-01 to Inv-08, as specified in Table 1, were prepared following the experimental procedures given below.

**Table 1: Comparative and inventive particulate particles**

| Particulate particles | Chemical composition |
|---|---|
| Comp-01 | Copolymer derived from anionic emulsion polymerization of butyl methacrylate and ethylene glycol dimethacrylate |
| Comp-02 | Copolymer derived from anionic emulsion polymerization of butyl acrylate, butyl methacrylate and ethylene glycol dimethacrylate |
| Comp-03 | Copolymer derived from anionic emulsion polymerization of butyl acrylate, butyl methacrylate and ethylene glycol dimethacrylate |
| Comp-04 | Copolymer derived from anionic emulsion polymerization of butyl methacrylate and ethylene glycol dimethacrylate |
| Comp-05 | Copolymer derived from non-ionic mini-emulsion polymerization of methyl methacrylate, ethylene glycol dimethacrylate and monoacrylate terminated polybutyl methacrylate |
| Inv-01 | Copolymer derived from anionic emulsion polymerization of butyl acrylate, butyl methacrylate and 3-methacryloxypropyltrimethoxysilane |
| Inv-02 | Copolymer derived from anionic emulsion polymerization of butyl acrylate, butyl methacrylate and vinyltrimethoxysilane |
| Inv-03 | Copolymer derived from anionic emulsion polymerization of butyl methacrylate and 3-methacryloxypropyltrimethoxysilane |
| Inv-04 | Copolymer derived from anionic emulsion polymerization of butyl methacrylate and vinyltrimethoxysilane |
| Inv-05 | Copolymer derived from anionic emulsion polymerization of butyl methacrylate and 3-methacryloxypropyltrimethoxysilane |
| Inv-06 | Copolymer derived from anionic emulsion polymerization of methyl methacrylate, 2-ethoxyhexylacrylate and 3-methacryloxypropyltrimethoxysilane |
| Inv-07 | Copolymer derived from anionic emulsion polymerization of methyl methacrylate and 3-methacryloxypropyltrimethoxysilane |
| Inv-08 | Copolymer derived from non-ionic mini-emulsion polymerization of methyl methacrylate, 3-methacryloxypropyltrimethoxysilane and monoacrylate terminated polybutyl methacrylate |

Unless otherwise specified, all compounds and solvents used in the Examples are readily available from fine chemical suppliers such as Acros or Sigma-Aldrich.

### 1.1 Synthesis of the comparative particulate particles Comp-01 to Comp-05

### Comp-01

In a double jacketed reactor of 2 l is added 10,8 SDS Ultrapure and 1310,4 g of demi-water. Under nitrogen atmosphere the reactor is heated to 75 °C. As soon as the reactor reaches 75 °C, 1,5% of the butyl methacrylate is added, i.e. 4,86 grams of butyl methacrylate. The reactor is heated then of 15 minutes at 75 °C. Afterwards 50% of the initiator solution is added, i.e. 59,4 g of a 2% potassium persulfate solution in water. The reactor is heated within 30 minutes to 80° C. The polymerization of the "seed" fraction causes the formation of an opalescent latex. Then, the remaining part of monomer is added, i.e. during the first 120 minutes 159,57 g of butylmethacrylate and subsequently during 60 minutes 159,57 g of butylmethacrylate and 36,0 g of ethylene glycol dimethacrylate. During the monomer dosing the remaining initiator solution is added (50% of the total amount), ie. 59,4 g of a 2% potassium persulfate solution in water during 180 minutes. After the monomer and initiator addition has finished the reactor is stirred for additionally 60 minutes at 80 °C. Afterwards the residual monomer is removed by distillation under reduced pressure during 90 minutes at and subsequently the reactor is cooled to room temperature and filtered over a coarse S & S paper. The resulting latex has a concentration of 20,66% and a particle size of 44 nm as measured by using a Malvern Zetasizer Nano S. pH = 2,25.

### Comp-02

In a double jacketed reactor of 2 l is added 10,8 SDS Ultrapure and 1310,4 g of demi-water. Under nitrogen atmosphere the reactor is heated to 75 °C. As soon as the reactor reaches 75 °C, 1,5% of the monofunctional acrylates is added, i.e. 2,43 g of butyl acrylate and 2,43 g of butyl methacrylate. The reactor is heated then of 15 minutes at 75 °C. Afterwards 50% of the initator solution is added, i.e. 59,4 g of a 2% potassium persulfate solution in water. The reactor is heated within 30 minutes to 80 °C. The polymerization of the "seed" fraction causes the formation of an opalescent latex. Then remaining part of monomer (98,5% of the total amount of the monofunctional acrylate monomers and 100% of the ethyleneglycol dimethacrylate) is added during 180 minutes, i.e. 159,57 g of butylacrylate, 159,57 g of butylmethacrylate and 36,0 g of ethylene glycol dimethacrylate. Simultaneously the remaining part of initiator solution is added (50% of the total amount), i.e. 59,4 g of a 2% potassium persulfate solution in water. After the monomer and initiator addition, the reactor is stirred for additionally 60 minutes at 80 °C. Afterwards the residual monomer is removed by distillation under reduced pressure during 90 minutes at and subsequently the reactor is cooled to room temperature and filtered over a coarse S & S paper. The resulting latex has a concentration of 20,24% and a particle size of 36 nm as measured by using a Malvern Zetasizer Nano S. pH = 2,64.

### Comp-03

This polymer dispersion is prepared by means of a mini-emulsion polymerization method. In a 1 l double jacketed reactor 54 g of Lutensol AT50 is dissolved in 599,4 g of demineralized water. The monomer mixture is weighted in a 250 ml Erlenmeyer, ie. 81 g of butylacrylate (BuA), 81 g of butylmethacrylate (BuMA), 18 g of ethyleneglycol dimethacrylate (EGDMA), and 7,2 g of hexadecane. Weight ratio of the monomers is 45/45/10 BuA/BuMA/EGDMA. The monomers are mixed together with the hexadecane using a magnetic stirrer. In another Erlenmeyer 1,19 g of potassium persulfate is dissolved in 58,21 g of water. The monomer mixture is then brought into an addition funnel with pressure equalization arm of 250 ml. We bring an Ultraturrax homogenizer into the surfactant solution which is present in the double jacketed reactor without reactor lid. The Ultraturrax is set to 11500 rotations/minute. The monomer mixture is added in approximately 20 minutes to the reactor. The Ultraturrax homogenizer is allowed to stir at high speed for another 10 minutes after the addition of the monomer mixture is finished. Afterwards the reactor is closed with the reactor lid, equipped with overhead stirrer, jacketed coil condensor and flushed with nitrogen. The overhead stirrer is set to 200 RPM and the reaction mixture is heated to 75°C. The jacket temperature is set to 78°C. When the reaction mixture has reached 75°C, the initiator solution is added immediately and the reactor is heated for 180 minutes with a jacket temperature of 78°C. Subsequently the residual monomer is removed by vacuum distillation, having the jacket temperature still at 78 °C and reducing the pressure to 400 mbar. The distillation is performed during 90 minutes and then the reactor is cooled to room temperature and filtered over coarse filter paper. The resulting latex has a concentration of 25,76% and a pH = 2,33. Particle size was measured using Malvern zetasizer giving a bimodal distribution, i.e. 10x diluted with water 62,0 nm (100%) or 10x diluted with NaCl aq (0,005M62,0 nm (98,1%) and 4845 nm (1,9%).

### Comp-04

In a 1 liter double jacketed reactor 54 g of Lutensol AT50 is dissolved in 599,4 g of demineralized water. The monomer mixture is weighted in a 250 ml Erlenmeyer, i.e. 171 g of butylmethacrylate (BuMA), 9 g of ethyleneglycol dimethacrylate (EGDMA), and 7,2 g of hexadecane. Weight ratio of the monomers is 95/5 BuMA/EGDMA. The monomers are mixed together with the hexadecane (added as cosurfactant to avoid droplet coalescence due to Oswalt ripening) using a magnetic stirrer. In another Erlenmeyer 1,19 g of potassium persulfate is dissolved in 58,21 g of water. The monomer mixture is then brought into an addition funnel with pressure equalization arm of 250 ml. We bring an Ultraturrax homogenizer into the surfactant solution which is present in the double jacketed reactor without reactor lid. The Ultraturrax is set to 11500 rotations/minute. The monomer mixture is added in appr. 20 minutes to the reactor. If too much foam is formed then the monomer is added a little slower. For this reaction the monomer mixture was added in 24 minutes. The Ultraturrax homogenizer is allowed to stir at high speed for another 10 minutes after the addition of the monomer mixture is finished. Afterwards the reactor is closed with the reactor lid, equipped with overhead stirrer, jacketed coil condensor and flushed with nitrogen. The overhead stirrer is set to 200 RPM and the reaction mixture is heated to 75°C. The jacket temperature is set to 78°C. When the reaction mixture has reached 75°C, we add the initiator solution immediately. Starting from the moment the initiator solution is added the reactor is heated for 180 minutes with a jacket temperature of 78°C. Subsequently the residual monomer is removed by vacuum distillation, having the jacket temperature still at 78°C and reducing the pressure to 400 mbar. The distillation is performed during 90 minutes and then the reactor is cooled to room temperature and filtered over coarse filter paper. The resulting latex has a concentration of 24,91% and a pH = 2,31. Particle size was measured using Malvern zetasizer giving a bimodal distribution, ie. 10x diluted with water 62,0 nm or 10x diluted with NaCl aq (0,005M) 63,0 nm.

### Comp-05

In a 1 liter double jacketed reactor 54 g of Lutensol AT50 is dissolved in 599,4 grams of demineralized water. The monomer mixture is weighted in a 250 ml Erlenmeyer, ie. 162 g of methyl methacrylate (MMA), 9 g of ethyleneglycol dimethacrylate (EGDMA), 9 g of polybutylacrylate macromere Kaneka MM110C and 7,2 g of hexadecane. Weight ratio of the monomers is 90/5/5 MMA/EGDMA/Kaneka MM110C. The monomers are mixed together with the hexadecane (added as cosurfactant to avoid droplet coalescence due to Oswalt ripening) using a magnetic stirrer. In another Erlenmeyer 1,19 g of potassium persulfate is dissolved in 58,21 g of water. The monomer mixture is then brought into an addition funnel with pressure equalization arm of 250 ml. We bring an Ultraturrax homogenizer into the surfactant solution which is present in the double jacketed reactor without reactor lid. The Ultraturrax is set to 11500 rotations/minute. The monomer mixture is added in approximately 20 minutes to the reactor. If too much foam is formed then the monomer is added a little slower. The Ultraturrax homogenizer is allowed to stir at high speed for another 10 minutes after the addition of the monomer mixture is finished. Afterwards the reactor is closed with the reactor lid, equipped with overhead stirrer, jacketed coil condensor and flushed with nitrogen. The overhead stirrer is set to 200 RPM and the reaction mixture is heated to 75°C. The jacket temperature is set to 78°C. When the reaction mixture has reached 75°C, we add the initiator solution immediately. The polymerization starts and due to an exothermic reaction the temperature increases to approximately 89,7 °C. Starting from the moment the initiator solution is added the reactor is heated for 180 minutes with a jacket temperature of 78°C. Subsequently the residual monomer is removed by vacuum distillation, having the jacket temperature still at 78°C and reducing the pressure to 400 mbar. The distillation is performed during 90 minutes and then the reactor is cooled to room temperature and filtered over coarse filter paper. The resulting latex has a concentration of 25,89% and a pH = 2,48. Particle size was measured using Malvern zetasizer giving a bimodal distribution, ie. 10x diluted with water 68,82 nm (79,8%) and 1480 nm (20,2%) or 10x diluted with NaCl aq (0,005M): 69,14 nm (63,1%) and 1420 nm (16,9%).

### 1.2 Synthesis of the inventive particulate particles Inv-01 to Inv-08

### Inv-01

In a double jacketed reactor of 2 liter is added 10,8 SDS Ultrapure and 1310,4 g of demi-water. Under nitrogen atmosphere the reactor is heated to 75 C. As soon as the reactor reaches 75C, 1,5% of the monomer mixture is added (only non functional acrylate monomers excl. the silane monomer), ie. 2,43 g of butyl acrylate and 2,43 g of butyl methacrylate. The reactor is heated then of 15 minutes at 75 °C. Afterwards 50% of the initator solution is added, ie. 59,4 g of a 2% potassium persulfate solution in water. The reactor is heated within 30 minutes to 80 °C. The polymerization of the "seed" fraction causes the formation of an opalescent latex. Then remaining part of monomer (98,5% of the total amount of nonreactive acrylate monomers and 100% of silane monomer) is added during 180 minutes, ie. 159,57 g of butylacrylate, 159,57 g of butylmethacrylate and 36,0 g of methacryloxy propyl trimethoxysilane (Dynasilan MEMO supplied by Evonik). Simultaneously the remaining part of initiator solution is added (50% of the total amount), i.e. 59,4 g of a 2% sodium persulfate solution in water. After the monomer and initiator addition has finished the reactor was stirred for additionally 60 minutes at 80°C. Afterwards the residual monomer is removed by distillation under reduced pressure during 90 minutes at and subsequently the reactor is cooled to room temperature and filtered over a coarse S & S paper. The resulting latex has a concentration of 20,17% and a particle size of 37 nm as measured by using a Malvern Zetasizer Nano S. pH = 2,29.

### Inv-02

In a double jacketed reactor of 2 liter is added 10,8 SDS Ultrapure and 1310,4 g of demi-water. Under nitrogen atmosphere the reactor is heated to 75°C. As soon as the reactor reaches 75C, 1,5% of the monomer mixture is added (only non functional acrylate monomers excl. the silane monomer), ie. 2,43 g of butyl acrylate and 2,43 g of butyl methacrylate. The reactor is heated then of 15 minutes at 75 °C. Afterwards 50% of the initator solution is added, ie. 59,4 g of a 2% potassium persulfate solution in water. The reactor is heated within 30 minutes to 80 °C. The polymerization of the "seed" fraction causes the formation of an opalescent latex. Then remaining part of monomer (98,5% of the total amount of nonreactive acrylate monomers and 100% of silane monomer) is added during 180 minutes, ie. 159,57 g of butylacrylate, 159,57 g of butylmethacrylate and 36,0 g of vinyltrimethoxysilane (supplied by Aldrich). Simultaneously the remaining part of initiator solution is added (50% of the total amount), i.e. 59,4 g of a 2% sodium persulfate solution in water, and then stirred for additionally 60 minutes at 80 °C. Afterwards the residual monomer is removed by distillation under reduced pressure during 90 minutes at and subsequently the reactor is cooled to room temperature and filtered over a coarse S & S paper. The resulting latex has a concentration of 20,19% and a particle size of 44 nm as measured by using a Malvern Zetasizer Nano S. pH = 3,45.

### Inv-03

In a double jacketed reactor of 2 liter is added 10,8 SDS Ultrapure and 1310,4 g of demi-water. Under nitrogen atmosphere the reactor is heated to 75 °C. As soon as the reactor reaches 75 °C, 1,5% of the butyl methacrylate monomer is added (excl. the silane monomer), i.e. 4,86 g of butyl methacrylate. The reactor is then heated for 15 minutes at 75 °C. Afterwards 50% of the initiator solution is added, i.e. 59,4 g of a 2% potassium persulfate solution in water. The reactor was heated within 30 minutes to 80 °C. The polymerization of the "seed" fraction causes the formation of an opalescent latex. Then remaining part of monomer (98,5% of the total amount of butylmethacrylate and 100% of silane monomer) is added during 180 minutes, i.e. 319,14 g of butylmethacrylate, and 36,0 g of methacryloxy propyl trimethoxy silane (Dynasilan MEMO supplied by Evonik). Simultaneously the remaining part of initiator solution is added (50% of the total amount), i.e. 59,4 g of a 2% sodium persulfate solution in water and then the reactor was stirred for additionally 60 minutes at 80 °C. Afterwards the residual monomer is removed by distillation under reduced pressure during 90 minutes at and subsequently the reactor is cooled to room temperature and filtered over a coarse S & S paper. The resulting latex has a concentration of 20,70% and a particle size of 55 nm as measured by using a Malvern Zetasizer Nano S. pH = 3,28.

### Inv-04

In a double jacketed reactor of 2 liter is added 10,8 SDS Ultrapure and 1310,4 g of demi-water. Under nitrogen atmosphere the reactor is heated to 75 C. As soon as the reactor reaches 75C, 1,5% of the monomer mixture is added (only butylmethacrylate monomer excl. the silane monomer), ie. 4,86 grams of butyl methacrylate. The reactor is heated then of 15 minutes at 75C. Afterwards 50% of the initator solution is added, ie. 59,4 grams of a 2% potassium persulfate solution in water. The reactor is heated within 30 minutes to 80 C. The polymerization of the "seed" fraction causes the formation of an opalescent latex. Then remaining part of monomer (98,5% of the butyl methacrylate monomer and 100% of silane monomer) is added during 180 minutes, ie. 319,14 grams of butylmethacrylate and 36,0 grams of vinyltrimethoxysilane (supplied by Aldrich). Simultaneously the remaining part of initiator solution is added (50% of the total amount), ie. 59,4 grams of a 2% sodium persulfate solution in water. After the monomer and initiator addition has finished we stir the reactor for additionally 60 minutes at 80 C. Afterwards the residual monomer is removed by distillation under reduced pressure during 90 minutes at and subsequently the reactor is cooled to room temperature and filtered over a coarse S & S paper. The resulting latex has a concentration of 19,62% and a particle size of 64 nm as measured by using a Malvern Zetasizer Nano S. pH = 3,58.

### Inv-05

In a double jacketed reactor of 1 liter is added 8,1 g of SDS Ultrapure and 532,8 g of demi-water. Under nitrogen atmosphere the reactor is heated to 75 °C. As soon as the reactor reaches 75 °C, 1,5% of the monomer mixture is added (only butylmethacrylate monomer excl. the silane monomer), ie. 3,65 g of butyl methacrylate. The reactor is heated then of 15 minutes at 75 °C. Afterwards 50% of the initiator solution is added, i.e. 44,55 g of a 2% potassium persulfate solution in water. The reactor is heated within 30 minutes to 80 24°C. The polymerization of the "seed" fraction causes the formation of an opalescent latex. Then remaining part of monomer (98,5% of the butyl methacrylate monomer and 100% of silane monomer) is added during 180 minutes, i.e. 239,36 g of butylmethacrylate and 27,0 g of 3-Methacryloxypropylmethyldimethoxysilane (supplied by ABCR). Simultaneously the remaining part of initiator solution is added (50% of the total amount), i.e. 44,55 g of a 2% sodium persulfate solution in water and then the reactor was stirred for additionally 60 minutes at 80 °C. Afterwards the residual monomer is removed by distillation under reduced pressure during 90 minutes at and subsequently the reactor is cooled to room temperature and filtered over a coarse S & S paper. The resulting latex has a concentration of 30,85% and a particle size of 46 nm as measured by using a Malvern Zetasizer Nano S. pH = 1,88.

### Inv-06

In a double jacketed reactor of 2 liter is added 16,2 g of SDS Ultrapure and 1065,6 of demi-water. Under nitrogen atmosphere the reactor is heated to 75 °C. As soon as the reactor reaches 75 °C, 1,5% of the monomer mixture is added (only methyl acrylate monomers excl. the silane monomer), i.e. 4,62 g of methyl methacrylate and 2,67 g of 2-ethylhexylacrylate. The reactor is then heated for 15 minutes at 75 °C. Afterwards 50% of the initator solution is added, i.e. 89,1 g of a 2% ammonium persulfate solution in water. The reactor is heated within 30 minutes to 80 °C. The polymerization of the "seed" fraction causes the formation of an opalescent latex. Then remaining part of monomer (98,5% of the butyl methacrylate monomer and 100% of silane monomer) is added during 180 minutes, i.e. 303,18 g of methyl methacrylate, 175,53 g of 2-ethylhexyl acrylate and 54,0 grams of 3-Methacryloxypropyltrimethoxysilane (Dynasilan MEMO supplied by Evonik). Simultaneously the remaining part of initiator solution is added (50% of the total amount), i.e. 89,1 g of a 2% ammonium persulfate solution in water. The reactor was stirred for additionally 60 minutes at 80 °C. Afterwards the residual monomer is removed by distillation under reduced pressure during 90 minutes at and subsequently the reactor is cooled to room temperature and filtered over a coarse S & S paper. The resulting latex has a concentration 30,49% and a particle size was measured of 86 nm as measured by using a Malvern Zetasizer Nano S. pH = 1,77.

### Inv-07

In a double jacketed reactor of 2 liter is added 10,8 g of SDS Ultrapure and 1310,4g of demi-water. Under nitrogen atmosphere the reactor is heated to 75 °C. As soon as the reactor reaches 75C, 1,5% of the monomer mixture is added (only methyl methacrylate monomer excl. the silane monomer), ie. 5,13 g of methyl methacrylate. The reactor is heated then of 15 minutes at 75 °C. Afterwards 50% of the initiator solution is added, ie. 59,4 g of a 2% potassium persulfate solution in water. The reactor is heated within 30 minutes to 80 °C. The polymerization of the "seed" fraction causes the formation of an opalescent latex. Then remaining part of monomer (98,5% of the butyl methacrylate monomer and 100% of silane monomer) is added during 180 minutes, i.e. 336,87 g of methyl methacrylate and 18,0 g of 3-Methacryloxypropyltrimethoxysilane (Dynasilan MEMO supplied by Evonik). Simultaneously the remaining part of initiator solution is added (50% of the total amount), i.e. 59,4 g of a 2% sodium persulfate solution in water. The reactor was stirred for additionally 60 minutes at 80 °C. Afterwards the residual monomer is removed by distillation under reduced pressure during 90 minutes at and subsequently the reactor is cooled to room temperature and filtered over a coarse S & S paper. The resulting latex has a concentration 20,04% and a particle size was measured of 95 nm as measured by using a Malvern Zetasizer Nano S. pH = 2,80.

### Inv-08

In a 1 liter double jacketed reactor 27 g of Lutensol AT50 is dissolved in 626,4 g of demineralized water. The monomer mixture is weighted in a 250 ml Erlenmeyer, i.e. 162 g of methyl methacrylate (MMA), 9 g of ethyleneglycol dimethacrylate (EGDMA), 9 g of methacryloxy propyl trimethoxy silane (Dynasilan MEMO supplied by Evonik) and 7,2 g of hexadecane. Weight ratio of the monomers is 90/5/5 MMA/EGDMA/Kaneka MM110C. The monomers were mixed together with the hexadecane using a magnetic stirrer. In another Erlenmeyer 1,19 g of potassium persulfate is dissolved in 58,21 g of water. The monomer mixture is then brought into an addition funnel with pressure equalization arm of 250 ml. An Ultraturrax homogenizer is brought into the surfactant solution which is present in the double jacketed reactor without reactor lid. The Ultraturrax is set to 11500 rotations/minute. The monomer mixture is added in approximately 20 minutes to the reactor. The Ultraturrax homogenizer is allowed to stir at high speed for another 10 minutes after the addition of the monomer mixture. Afterwards the reactor is closed with the reactor lid, equipped with overhead stirrer, jacketed coil condensor and flushed with nitrogen. The overhead stirrer is set to 200 RPM and the reaction mixture is heated to 75°C. The jacket temperature is set to 78°C. When the reaction mixture has reached 75°C, the initiator solution is added immediately. The polymerization starts and due to an exothermic reaction the temperature increases to approximately 89,2°C. Starting from the moment the initiator solution is added the reactor is heated for 180 minutes with a jacket temperature of 78°C. Subsequently the residual monomer is removed by vacuum distillation, having the jacket temperature still at 78°C and reducing the pressure to 400 mbar. The distillation is performed during 90 minutes and then the reactor is cooled to room temperature and filtered over coarse filter paper. The resulting latex has a concentration of 23,07% and a pH = 2,42. Particle size was measured using Malvern zetasizer, ie. 10x diluted with water 93 nm or 10x diluted with NaCl aq (0,005M): 694nm (97,8%) and 4942 nm (2,2%).

### EXAMPLE 1

### Preparation of the aluminium support S-01

A 0.3 mm thick aluminium foil was degreased by spraying with an aqueous solution containing 26 g/l NaOH at 65°C for 2 seconds and rinsed with demineralised water for 1.5 seconds. The foil was then electrochemically grained during 10 seconds using an alternating current in an aqueous solution containing 15 g/l HCl, 15 g/l SO42- ions and 5 g/l Al3+ ions at a temperature of 37°C and a current density of about 100 A/dm2. Afterwards, the aluminium foil was then desmutted by etching with an aqueous solution containing 5.5 g/l of NaOH at 36°C for 2 seconds and rinsed with demineralised water for 2 seconds. The foil was subsequently subjected to anodic oxidation during 15 seconds in an aqueous solution containing 145 g/l of sulfuric acid at a temperature of 50°C and a current density of 17 A/dm2, then washed with demineralised water for 11 seconds and dried at 120°C for 5 seconds.

### Preparation of printing plates PP-01 to PP-13

### Photopolymerizable layer

The photopolymerizable layer was produced by coating onto the above described support S-01 the components as defined in Table 2, dissolved in a mixture of 35% by volume of MEK and 65% by volume of Dowanol PM (1-methoxy-2-propanol, commercially available from DOW CHEMICAL Company). The coating solution was applied at a wet coating thickness of 30 µm and then dried at 120°C for 1 minute in a circulation oven.

**Table 2: Composition of photopolymerizable layer PL-01**

| **Ingredients** | **mg/m²** |
|---|---|
| FST 510 (1) | 250 |
| CN 104 (2) | 250 |
| Ini-01 (3) | 60 |
| Sodium tetraphenylborate | 20 |
| IR-01 (4) | 20 |
| Particulate binder (5) | 250 |
| Tegoglide 410 (6) | 1.5 |
| JPA 528 (7) | 130 |
| Belclene 400 (8) | 15 |
| Aerosil 150 (9) | 85 |
| H₃PO₄ | 6.5 |

| | |
|---|---|
| (1) FST 510 is a reaction product from 1 mole of 2,2,4-trimethylhexamethylenediisocyanate and 2 moles of hydroxyethyl-methacrylate commercially available from AZ Electronics as a 82 wt.% solution in MEK; (2) CN 104 is an epoxy acrylate oligomer commercially available from Arkema; (3) Ini-01 is 4-hydroxyphenyl-tribromomethyl-sulfone; (4) IR-01 is an infrared absorbing compound represented by the following structure: 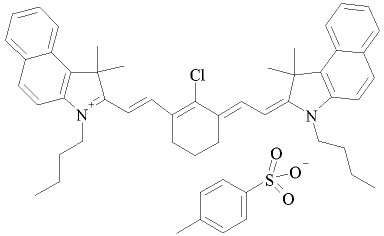 (5) The particulate binders are described above and the respective printing plate precursors PPP-01 to PPP-13 follow Table 3: | |

**Table 3: Printing plate precursors PPP-01 to PPP-13.**

| **Printing plate Precursor** | **Particulate binder** |
|---|---|
| PPP-01 | Comp-01 |
| PPP-02 | Comp-02 |
| PPP-03 | Comp-03 |
| PPP-04 | Comp-04 |
| PPP-05 | Comp-05 |
| PPP-06 | Inv-01 |
| PPP-07 | Inv-02 |
| PPP-08 | Inv-03 |
| PPP-09 | Inv-04 |
| PPP-10 | Inv-05 |
| PPP-11 | Inv-06 |
| PPP-12 | Inv-07 |
| PPP-13 | Inv-08 |

| | |
|---|---|
| (6) Tegoglide 410 is a polyether siloxane copolymer commercially available from Evonik Resource Efficiency GmbH; (7) JPA 528 is a polyethylene glycol monomethacrylate acid phosphate commercially available from Johoku Chemical Co., Ltd.; (8) Belclene 400 is a phosphinocarboxylic acid commercially available from BWA Water Additives UK Ltd.; (9) Aerosil 150 is a hydrophilic fumed silica commercially available from Evonik Resource Efficiency GmbH. | |

### Protective overcoat layer

On top of the photosensitive layer, an aqueous solution with the composition as defined in Table 4 was coated (40 µm wet film), and dried at 110°C for 2 minutes.

**Table 4: Composition of protective overcoat layer**

| **Ingredients** | **mg/m²** |
|---|---|
| Mowiol 4-88 (1) | 80 |
| Mowiol 28-99 (2) | 80 |
| Diofan A050 (3) | 296 |
| Acticide LA1206 (4) | 1 |
| Lutensol A8 (5) | 2.2 |
| Aquacer 537 (6) | 6.5 |
| IR-02 (7) | 29 |

| | |
|---|---|
| (1) Mowiol 4-88TM is a partially hydrolyzed polyvinylalcohol commercially available from Kuraray; (2) Mowiol 28-99 is a fully hydrolyzed polyvinylalcohol commercially available from Kuraray; (3) Diofan A050 is a polyvinylidene chloride latex commercially available from Solvay; (4) Acticide LA1206TM is a biocide commercially available from Thor; (5) Lurtensol A8 is a high speed fluorosurfactant available from Merck; (6) Aquacer 537 is a paraffin wax emulsion commercially available from BYK; (7) IR-02 is an infrared absorbing dye having the following formula: | |

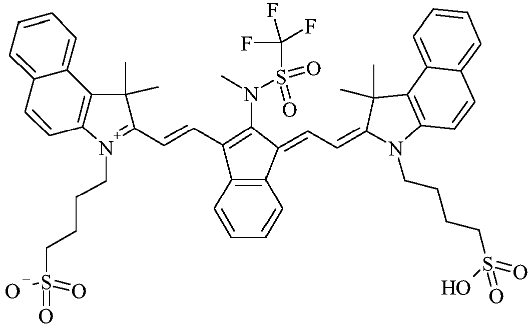

### Accelerated ageing

The resulting printing plate precursors PPP-01 to PPP-13 were subsequently subjected to an accelerated ageing test in a climate chamber for 3 days at 50°C or subjected to a humidity resistance test for 3 days at 75% relative humidity and 26°C.

### Imaging

The printing plate precursors were subsequently imaged at 2400 dpi with a High Power Creo 40W TE38 thermal platesetterTM (200 lpi Agfa Balanced Screening (ABS)), commercially available from Kodak and equipped with a 830 nm IR laser diode, at energy density of 130 mJ/cm².

### On-press developability

After imaging, the printing plate precursors were assessed for their on-press developability. Printing plate precursors (1) without treatment, (2) subjected to the climate chamber or (3) subjected to the humidity resistance test, were mounted on a Heidelberg GTO 52 Dalghren printing press. Each print job was started using K+E Skinnex 800 SPEED IK black ink (trademark of BASF Druckfarben GmbH) and 4 wt% Prima FS303 SF (trademark of Agfa Graphics) and 8% isopropanol in water as fountain solution. A compressible blanket was used and printing was performed on non-coated offset paper.

Prior to paper feeding, 10 press revolutions with only the dampening system engaged followed by 5 revolutions with the inking rollers engaged was performed. The amount of pages needed to reach toning-free sheets in the non-image areas was assessed as well as the ink acceptance of the image areas.

### Press durability

The imaged printing plate precursors were mounted on a Drent Vision web press. Each print job was started using Supra UV (trademark of Jannecke and Schneemann) magenta UV ink and 2.5 wt% Prima FS404 AS (trademark of Agfa Graphics) and 2.5% isopropanol in water as fountain solution.

A ContiAir Ebony 196 blanket was used and printing was performed on newspaper stock. Blanket cleaning was performed each 10.000 impressions using Antura Wash UV74 (Supra UV ink), trademark of Agfa Graphics.

### Results

Binders constituted mainly from butyl (meth)acrylate.

The amount of pages required to obtain toning-free non-image areas and sufficient ink density in the image areas, should be as low as possible. Additionally, the on-press development properties - i.e. sufficient clean out of the non-image areas and/or sufficient ink density at the image areas - should remain stable at increased humidity and/or temperature increase.

The results of toning behaviour of the non image areas and level of ink density of the image areas of untreated printing plates and printing plates treated at elevated temperature and/or humidity, are summarized in the Tables 5 and 6 below.

**Table 5: Toning behaviour of the non-image areas on print***

| Printing Plate | Untreated | 3 days at 50°C | 3 days at 75% relative humidity (26°C) |
|---|---|---|---|
| PP-01 | + | + | - |
| *Comp-01* | | | |
| PP-02 | + | + | - |
| *Comp-02* | | | |
| PP-03 | + | + | - |
| *Comp-03* | | | |
| PP-04 | ++ | ++ | + |
| *Comp-04* | | | |
| PP-06 | +++ | +++ | ++ |
| *Inv-01* | | | |
| PP-07 | +++ | +++ | ++ |
| *Inv-02* | | | |
| PP-08 | +++ | +++ | ++ |
| *Inv-03* | | | |
| PP-09 | +++ | +++ | ++ |
| *Inv-04* | | | |
| PP-10 | +++ | ++ | ++ |
| *Inv-05* | | | |

| | | | |
|---|---|---|---|
| * A quotation of toning free non-image areas is given by visual inspection of the prints. A score is given based on the amount of printed sheets required to have a toning-free print in the non-image areas at a rating according to: - - : 40-50 sheets - : 20-30 sheets + : 10-20 sheets ++ : 5-10 sheets +++ : less than 5 sheets | | | |

**Table 6: Image area density****

| Printing Plate | Untreated | 3 days at 50°C | 3 days at 75% relative humidity (26°C) |
|---|---|---|---|
| PP-01 | + | - | - |
| *Comp-01* | | | |
| PP-02 | - | - | -- |
| *Comp-02* | | | |
| PP-03 | - | -- | -- |
| *Comp-03* | | | |
| PP-04 | + | + | - |
| *Comp-04* | | | |
| PP-06 | ++ | ++ | + |
| *Inv-01* | | | |
| PP-07 | ++ | ++ | + |
| *Inv-02* | | | |
| PP-08 | ++ | ++ | + |
| *Inv-03* | | | |
| PP-09 | ++ | ++ | + |
| *Inv-04* | | | |
| PP-10 | + | + | + |
| *Inv-05* | | | |

| | | | |
|---|---|---|---|
| ** A quotation of toning free non-image area is given by visual inspection of the prints. A score is given based on the amount of printed sheets required to have toning-free print in the non-image areas at a rating according to: - - : 40-50 sheets - : 20-30 sheets + : 10-20 sheets ++ : 5-10 sheets +++ : less than 5 sheets | | | |

The results show that:
- the untreated printing plates, both comparative and inventive printing plates, demonstrate a good on-press development (Table 5: toning behaviour of image areas and Table 6: clean out behaviour of non-image areas);
- the inventive printing plates show a very good on-press development after accelerated ageing conditions.

The press life was evaluated by visual assessment of image wear after 30 000 impressions. The results are given in Table 7.

**Table 7: Press life under UV conditions *****

| Printing Plate | Press life |
|---|---|
| PP-01 | - |
| *Comp-01* | |
| PP-02 | + |
| *Camp-02* | |
| PP-03 | - |
| *Comp-03* | |
| PP-04 | + |
| *Comp-04* | |
| PP-06 | ++ |
| *Inv-01* | |
| PP-07 | ++ |
| *Inv-02* | |
| PP-08 | ++ |
| *Inv-03* | |
| PP-09 | ++ |
| *Inv-04* | |
| PP-10 | ++ |
| *Inv-05* | |

| | |
|---|---|
| *** A quotation of the printing plate press life is given according to: - : significant wear after 30 000 impressions + : some wear after 30 000 impressions ++ : no wear after 30 000 impressions | |

The results in Table 7 show that the inventive printing plates demonstrate a good press life under UV ink printing while the press life of the comparative printing plates is significantly lower.

Binders constituted mainly from methyl methacrylate.

The amount of pages needed to obtain toning-free non-image areas and sufficient ink density in the image areas, are given in Table 8. Furthermore, the on-press development properties - i.e. sufficient clean out of the non-image areas and/or sufficient ink density at the image areas - was measured at increased humidity and/or temperature increase.

**Table 8: Toning behaviour of the non-image areas on print***

| Printing Plate | Untreated | 3 days at 50°C | 3 days at 75% relative humidity (26°C) |
|---|---|---|---|
| PP-05 | + | + | - |
| *Comp-05* | | | |
| PP-11 | +++ | ++ | ++ |
| *Inv-11* | | | |
| PP-12 | +++ | + | + |
| *Inv-12* | | | |
| PP-13 | +++ | +++ | +++ |
| *Inv- 13* | | | |

| | | | |
|---|---|---|---|
| * A quotation of toning free non-image areas is given by visual inspection of the prints. A score is given based on the amount of printed sheets required to have a toning-free print in the non-image areas at a rating according to: - - : 40-50 sheets - : 20-30 sheets + : 10-20 sheets ++ : 5-10 sheets +++ : less than 5 sheets | | | |

The results in Table 8 show that the untreated inventive and comparative printing plates demonstrate a good on-press development in terms of toning behaviour of the non image areas; while the toning behaviour of the treated comparative printing plate deteriorates after three days at 75% humidity.

**Table 9: Image area density****

| Printing Plate | Untreated | 3 days at 50°C | 3 days at 75% relative humidity (26°C) |
|---|---|---|---|
| PP-05 | - | - | - |
| *Comp-05* | | | |
| PP-11 | + | + | - |
| *Inv-11* | | | |
| PP-12 | + | + | + |
| *Inv-12* | | | |
| PP-13 | + | - | - |
| *Inv-13* | | | |

| | | | |
|---|---|---|---|
| ** A quotation of toning free non-image area is given by visual inspection of the prints. A score is given based on the amount of printed sheets required to have toning-free print in the non-image areas at a rating according to: - - : 40-50 sheets - : 20-30 sheets + : 10-20 sheets ++ : 5-10 sheets +++ : less than 5 sheets | | | |

The results in Table 9 show that the (treated and untreated) comparative printing plate has a worse on-press development in terms of ink density at the image areas compared to the inventive printing plates.

The press life under UV conditions was evaluated by visual assessment of image wear after 30 000 impressions. The results are given in Table 10.

**Table 10: Press life under UV conditions *****

| Printing Plate | Press life |
|---|---|
| PP-05 | - |
| *Comp-05* | |
| PP-11 | ++ |
| *Inv-11* | |
| PP-12 | ++ |
| *Inv-12* | |
| PP-13 | ++ |
| *Inv- 13* | |

| | |
|---|---|
| *** A quotation of the printing plate press life is given according to: - : significant wear after 30 000 impressions + : some wear after 30 000 impressions ++ : no wear after 30 000 impressions | |

The results show that the inventive printing plates show a good press life under UV conditions while the press life of the comparative printing plate under UV conditions is significantly lower.

## Claims

1. A lithographic printing plate precursor including a support which has a hydrophilic surface or which is provided with a hydrophilic layer and a coating comprising a photopolymerizable layer including a polymerisable compound, a photoinitiator, a particulate binder and optionally a sensitizer, wherein the particulate binder comprises repeating units derived from the monomers selected from alkylacrylates, alkylmethacrylates, acrylamides, methacrylamides, vinylesters or vinylacetamides and/or repeating units comprising a segment including urethanes and/or a polyurea, and/or combinations thereof, and wherein the particulate binder comprises a plurality of silane groups, and/or silanol groups and/or siloxane reaction products of said silane and/or silanol groups.

2. The precursor according to claim 1 wherein the particulate binder includes silicium based crosslinks.

3. The precursor according to any of the preceding claims wherein the particulate binder comprises repeating units derived from the monomers selected from methylmethacrylate, ethyl methacrylate, propylmethacrylate, butylmethacrylate, allylmethacrylate, 2-ethylhexylmethacrylate, cyclohexylmethacrylate, methylacrylate, ethylacrylate, propylacrylate, butylacrylate, allylacrylate, 2-ethylhexylacrylate and cyclohexylacrylate, acrylamides such as N-alkylacrylamides, methacrylamides such as N-alkylmethacrylamides.

4. The precursor according to any of the preceding claims wherein the particulate binder comprises repeating units derived from the monomers selected from alkylacrylates or alkylmethacrylates wherein the alkyl group has three or more carbon atoms.

5. The precursor according to any of the preceding claims wherein the plurality of silane groups and/or silanol groups are directly attached to the particulate binder with a carbon/silicium bond, or through a linking group.

6. The precursor according to any of the preceding claims wherein the photopolymerizable layer further includes 1 to 40 % of silica particles having surface hydroxyl groups.

7. The precursor according to any of the preceding claims wherein the size of the particulate binder is smaller than the thickness of the coating.

8. The precursor according to any of the preceding claims wherein the glass transition temperature of the particulate binder is above 5 ° C.

9. The precursor according to any of the preceding claims wherein the particulate binder includes at least 2 wt% by weight repeating units derived from alkoxy silane containing monomers.

10. The precursor according to claim 9 wherein the alkoxy silane containing monomers are selected form dialkoxy silanes and/or trialkoxysilanes.

11. The precursor according to any of the preceding claims wherein the coating is capable of being developed on-press with dampening liquid and/or ink.

12. A method for making a lithographic printing plate precursor including the steps of
- applying on a support a coating as defined in claims 1 to 11 and
- drying the precursor.

13. A method for making a printing plate including the steps of
- image-wise exposing the printing plate precursor according to claims 1 to 11 to heat and/or light;
- developing the precursor.

14. The method according to claim 13 wherein the precursor is developed by mounting the precursor on a plate cylinder of a lithographic printing press and rotating the plate cylinder while feeding dampening liquid and/or ink to the precursor.

## Patentansprüche

1. Ein lithografischer Druckplattenvorläufer, umfassend einen Träger mit einer hydrophilen Oberfläche oder einem mit einer hydrophilen Schicht versehenen Träger und eine Beschichtung, umfassend eine fotopolymerisierbare Schicht, enthaltend eine polymerisierbare Verbindung, einen Fotoinitiator, ein partikelförmiges Bindemittel und gegebenenfalls einen Sensibilisator, wobei das partikelförmige Bindemittel Wiederholeinheiten, die abgeleitet sind von den Monomeren, die aus Alkylacrylaten, Alkylmethacrylaten, Acrylamiden, Methacrylamiden, Vinylestern oder Vinylacetamiden gewählt werden, und/oder Wiederholeinheiten, die ein Urethane und/oder einen Polyharnstoff enthaltendes Segment umfassen, und/oder Kombinationen derselben enthält, und wobei das partikelförmige Bindemittel eine Vielzahl von Silangruppen und/oder Silanolgruppen und/oder Siloxanreaktionsprodukten der Silangruppen und/oder Silanolgruppen umfasst.

2. Der Vorläufer nach Anspruch 1, wobei das partikelförmige Bindemittel Vernetzungen auf Siliciumbasis enthält.

3. Der Vorläufer nach einem der vorstehenden Ansprüche, wobei das partikelförmige Bindemittel Wiederholeinheiten umfasst, die abgeleitet sind von den Monomeren, die aus Methylmethacrylat, Ethylmethacrylat, Propylmethacrylat, Butylmethacrylat, Allylmethacrylat, 2-Ethylhexylmethacrylat, Cyclohexylmethacrylat, Methylacrylat, Ethylacrylat, Propylacrylat, Butylacrylat, Allylacrylat, 2-Ethylhexylacrylat und Cyclohexylacrylat, Acrylamiden, wie N-Alkylacrylamiden, und Methacrylamiden, wie N-Alkylmethacrylamiden, gewählt werden.

4. Der Vorläufer nach einem der vorstehenden Ansprüche, wobei das das partikelförmige Bindemittel Wiederholeinheiten, die abgeleitet sind von den Monomeren, gewählt aus Alkylacrylaten oder Alkylmethacrylaten, in denen die Alkylgruppe drei oder mehr Kohlenstoffatome umfasst, enthält.

5. Der Vorläufer nach einem der vorstehenden Ansprüche, wobei die Vielzahl von Silangruppen und/oder Silanolgruppen direkt über eine Kohlenstoff/Silicium-Bindung oder über eine Verbindungsgruppe an das partikelförmige Bindemittel gebunden ist.

6. Der Vorläufer nach einem der vorstehenden Ansprüche, wobei die fotopolymerisierbare Schicht ferner zwischen 1 Gew.-% und 40 Gew.-% Silicapartikel mit Oberflächen-Hydroxylgruppen umfasst.

7. Der Vorläufer nach einem der vorstehenden Ansprüche, wobei die Größe des partikelförmigen Bindemittels kleiner ist als die Stärke der Beschichtung.

8. Der Vorläufer nach einem der vorstehenden Ansprüche, wobei der Glasübergangstemperatur des partikelförmigen Bindemittels bei mehr als 5°C liegt.

9. Der Vorläufer nach einem der vorstehenden Ansprüche, wobei das partikelförmige Bindemittel mindestens 2 Gew.-% Wiederholeinheiten, die von Alkoxysilan enthaltenden Monomeren abgeleitet sind, enthält.

10. Der Vorläufer nach Anspruch 9, wobei die Alkoxysilan enthaltenden Monomere aus Dialkoxysilanen und/oder Trialkoxysilanen gewählt werden.

11. Der Vorläufer nach einem der vorstehenden Ansprüche, wobei die Beschichtung auf der Presse mit Feuchtwasser und/oder Tinte entwickelt werden kann.

12. Ein Verfahren zur Herstellung eines lithografischen Druckplattenvorläufers, das die folgenden Schritte umfasst:
- Beschichten eines Trägers mit einer wie nach einem der Ansprüche 1 bis 11 definierten Beschichtung, und
- Trocknung des Vorläufers.

13. Ein Verfahren zur Herstellung einer Druckplatte, das die folgenden Schritte umfasst:
- bildweises Erwärmen und/oder Belichten des Druckplattenvorläufers nach den Ansprüchen 1 bis 11, und
- Entwicklung des Vorläufers.

14. Das Verfahren nach Anspruch 13, wobei zur Entwicklung des Vorläufers der Vorläufer auf einen Plattenzylinder einer lithografischen Druckmaschine aufgespannt wird und bei sich drehendem Plattenzylinder Feuchtwasser und/oder Tinte auf den Vorläufer angebracht wird (werden).

## Revendications

1. Précurseur de plaque d'impression lithographique comprenant un support ayant une surface hydrophile ou un support revêtu d'une couche hydrophile et un revêtement comprenant une couche photopolymérisable contenant un composé polymérisable, un photo-initiateur, un liant particulaire et éventuellement un sensibilisateur, **caractérisé en ce que** le liant particulaire comprend des unités répétitives dérivées des monomères choisis parmi des acrylates d'alkyle, des méthacrylates d'alkyle, des acrylamides, des méthacrylamides, des esters vinyliques ou des acétamides de vinyle et/ou des unités répétitives comprenant un segment contenant des uréthanes et/ou une polyurée, et/ou des combinaisons de celles-ci,
et **caractérisé en ce que** le liant particulaire comprend une multitude de groupes silane et/ou de groupes silanol et/ou des produits de réaction de siloxane desdits groupes silane et/ou groupes silanol.

2. Précurseur selon la revendication 1, **caractérisé en ce que** le liant particulaire comprend des réticulations à base de silicium.

3. Précurseur selon l'une quelconque des revendications précédentes, **caractérisé en ce que** le liant particulaire comprend des unités répétitives dérivées des monomères choisis parmi le méthacrylate de méthyle, le méthacrylate d'éthyle, le méthacrylate de propyle, le méthacrylate de butyle, le méthacrylate d'allyle, le méthacrylate de 2-éthylhexyle, le méthacrylate de cyclohexyle, l'acrylate de méthyle, l'acrylate d'éthyle, l'acrylate de propyle, l'acrylate de butyle, l'acrylate d'allyle, l'acrylate de 2-éthylhexyle et l'acrylate de cyclohexyle, des acrylamides, tels que des acrylamides de N-alkyle, et des méthacrylamides, tels que des méthacrylamides de N-alkyle.

4. Précurseur selon l'une quelconque des revendications précédentes, **caractérisé en ce que** le liant particulaire comprend des unités répétitives dérivées des monomères choisis parmi des acrylates d'alkyle ou des méthacrylates d'alkyle dans lesquels le groupe alkyle comprend au moins trois atomes de carbone.

5. Précurseur selon l'une quelconque des revendications précédentes, **caractérisé en ce que** la multitude de groupes silane et/ou de groupes silanol est directement liée au liant particulaire par le biais d'une liaison carbone/silicium ou d'un groupe de liaison.

6. Précurseur selon l'une quelconque des revendications précédentes, **caractérisé en ce que** la couche photopolymérisable contient en outre entre 1% en poids et 40% en poids de particules de silice comprenant des groupes hydroxyle superficiels.

7. Précurseur selon l'une quelconque des revendications précédentes, **caractérisé en ce que** la taille du liant particulaire est inférieure à l'épaisseur du revêtement.

8. Précurseur selon l'une quelconque des revendications précédentes, **caractérisé en ce que** la température de transition vitreuse du liant particulaire est supérieure à 5°C.

9. Précurseur selon l'une quelconque des revendications précédentes, **caractérisé en ce que** le liant particulaire contient au moins 2% en poids d'unités répétitives dérivées de monomères contenant de l'alcoxysilane.

10. Précurseur selon la revendication 9, **caractérisé en ce que** les monomères contenant de l'alcoxysilane sont choisis parmi des dialcoxysilanes et/ou des trialcoxysilanes.

11. Précurseur selon l'une quelconque des revendications précédentes, **caractérisé en ce que** le revêtement peut être développé sur la presse en utilisant une solution de mouillage et/ou de l'encre.

12. Procédé pour la fabrication d'un précurseur de plaque d'impression lithographique comprenant les étapes consistant à:
- revêtir un support d'un revêtement tel que défini selon l'une quelconque des revendications 1 à 11, et
- sécher le précurseur.

13. Procédé pour la fabrication d'une plaque d'impression comprenant les étapes consistant à:
- exposer sous forme d'image à de la chaleur et/ou à de la lumière le précurseur de plaque d'impression selon les revendications 1 à 11, et
- développer le précurseur.

14. Procédé selon la revendication 13, **caractérisé en ce que** le précurseur est développé en serrant le précurseur sur un cylindre porte-plaque d'une machine à imprimer lithographique et en faisant tourner le cylindre porte-plaque pendant qu'un liquide de mouillage et/ou de l'encre est (sont) appliqué(e) (s) sur ledit précurseur.
